(19) Europäisches Patentamt
European Patent Office
Office européen des brevets

(11) EP 3 117 993 B1

(12) # EUROPEAN PATENT SPECIFICATION

(45) Date of publication and mention of the grant of the patent:
**30.01.2019 Bulletin 2019/05**

(51) Int Cl.:
***B32B 17/10** (2006.01)* ***B32B 7/06** (2019.01)*
***B32B 15/088** (2006.01)* ***B32B 18/00** (2006.01)*

(21) Application number: **16001684.6**

(22) Date of filing: **16.12.2009**

(54) **LAMINATED BODY, MANUFACTURING METHOD THEREOF, AND LAMINATED CIRCUIT BOARD**

LAMINIERTER KÖRPER, HERSTELLUNGSVERFAHREN DAFÜR UND LAMINIERTE LEITERPLATTE

CORPS STRATIFIÉ, PROCÉDÉ DE FABRICATION ASSOCIÉ ET CARTE DE CIRCUIT STRATIFIÉE

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **19.12.2008 JP 2008323766**
**03.04.2009 JP 2009090997**
**27.04.2009 JP 2009107489**

(43) Date of publication of application:
**18.01.2017 Bulletin 2017/03**

(62) Document number(s) of the earlier application(s) in accordance with Art. 76 EPC:
**09833448.5 / 2 380 732**

(73) Proprietor: **Toyobo Co., Ltd.**
**Osaka-shi**
**Osaka 530-8230 (JP)**

(72) Inventors:
- **OKUYAMA, Tetsuo**
  **Ohtsu-shi, Shiga, 520-0292 (JP)**
- **WAKUI, Hiroyuki**
  **Ohtsu-shi, Shiga, 520-0292 (JP)**
- **YOSHIDA, Takehumi**
  **Ohtsu-shi, Shiga, 520-0292 (JP)**
- **TSUTSUMI, Masayuki**
  **Ohtsu-shi, Shiga, 520-0292 (JP)**
- **OKAMOTO, Jun**
  **Ohtsu-shi, Shiga, 520-0292 (JP)**
- **TSUTIYA, Toshiyuki**
  **Ohtsu-shi, Shiga, 520-0292 (JP)**
- **MAEDA, Satoshi**
  **Ohtsu-shi, Shiga, 520-0292 (JP)**

(74) Representative: **Müller-Boré & Partner Patentanwälte PartG mbB**
**Friedenheimer Brücke 21**
**80639 München (DE)**

(56) References cited:
**EP-A1- 1 872 940** **EP-A1- 1 872 941**
**JP-A- 2007 176 055** **JP-A- 2008 044 230**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 117 993 B1

## Description

TECHNICAL FIELD

The present invention relates to a laminated body used for production of electronic devices and the like, the laminated body is a laminate of a thin polyimide film having a coefficient of linear expansion in a relatively low specific range and being excellent in heat resistance and insulation, and an inorganic layer of a type selected from a glass plate, a ceramic plate, and a silicon wafer having a coefficient of linear expansion substantially comparable to that of the polyimide film, and the laminated body is excellent in dimensional stability, heat resistance, and insulation.

BACKGROUND ART

Polyimide films have properties exhibiting an extremely small variation in a wide temperature range of -269°C to 300°C, and therefore, the use and the application of polyimide films in the electrical and electronic fields are expanding. In the electrical field, polyimide films are used for example for coil insulation in a vehicle's motor, an industrial motor and the like, and insulation of an aircraft's electrical wire, a superconducting wire and the like. In the electronic field, polyimide films are used for example for a flexible printed circuit board, a base film of a film carrier for semiconductor packaging, and the like. As seen from above, polyimide films that are extremely reliable among various kinds of functional polymer films are used widely in the electrical and electronic fields.

Ceramic has conventionally been used as a material for a base of an electronic component such as information communication device (broadcast device, mobile wireless device, portable communication device and the like), radar, and high-speed information processor. A ceramic base has heat resistance and is also adaptable to increased frequencies (to the GHz range) of the signal band for information communication devices in these years. Ceramic, however, is not flexible and cannot be made thin, which restricts the applicable field of ceramic.

In view of this, studies have been conducted on the use of a film of an organic material as a base of an electronic component, and polyimide films and polytetrafluoroethylene films have been proposed. Polyimide films are excellent in heat resistance. Further, polyimide films are strong and therefore have an advantage that the films can be made thin.

A problem of these polyimide films is that the coefficient of linear expansion is generally large and a dimensional variation caused by a temperature variation is significantly large and therefore the polyimide films are not suitable for manufacture of circuits having microscopic interconnections. The applicable field of polyimide films is accordingly restricted. As seen from above, a film having heat resistance, high mechanical properties, and flexibility and properties adequate for a base has not been obtained.

As a polyimide film with a higher tensile elastic modulus, a polyimide benzoxazole film made of a polyimide having a benzoxazole ring as a principal chain has been proposed (see Patent Document 1). A printed wiring board having this polyimide benzoxazole film as a dielectric layer has also been proposed (see Patent Documents 2 and 3).

These polyimide benzoxazole films made of a polyimide having a benzoxazole ring as a principal chain have improved tensile rupture strength and tensile elastic modulus as well as a satisfactory range of the coefficient of linear expansion. While polyimide benzoxazole films have excellent mechanical properties, the films of decreased thicknesses are more difficult to handle, leaving problems such as mechanical and dynamical insufficiencies.

Attempts have been made in which an adhesive layer such as thermoplastic resin is provided on the polyimide film and another reinforcement structure is provided. However, even if structural improvements are satisfactory, the low heat resistance of the thermoplastic resin tends to impair the heat resistance of the polyimide film.

Patent Document 1: Japanese Patent Laying-Open No. 06-056992
Patent Document 2: Japanese Patent Laying-Open No. 11-504369
Patent Document 3: Japanese Patent Laying-Open No. 11-505184

DISCLOSURE OF THE INVENTION

PROBLEMS TO BE SOLVED BY THE INVENTION

A laminated body is provided that enables accurate positioning to produce multiple layers of thin films and form circuits and the like when an electronic device is produced.

When an electronic device is to be produced in which accurate positioning is performed to produce multiple layers of thin films and form circuits and the like, a film having inadequate dimensional stability and varying shape makes it difficult to perform positioning for producing the device. Therefore, for a method in which a film is secured to a hard substrate of excellent dimensional stability and the hard substrate is peeled off after the device is produced, a laminated body having a peel strength that allows a film and the substrate to be smoothly peeled off from each other and prevents

peeling during the process has been required. With such a laminated body, the conventional electronic device production process can be used as it is and the device can be produced on the film stably and precisely.

In the case where a varnish is applied onto a wafer and the varnish is thereafter peeled off to form a film, the film thickness distribution of the wafer is concentric. In contrast, when a separately produced film is attached, the film thickness is extremely uniform in a small area such as wafer and glass, which is suitable for circuit production. Because of structural differences between the front and the back of the film, the peeled film is warped, and it is difficult to keep an appropriate peel strength, peel and keep properties of the film. In the case where a separately produced film is attached, the film thickness is extremely uniform in a small area such as wafer and glass, and the film can be attached after a circuit is generated in advance, or the circuit can be generated

MEANS FOR SOLVING THE PROBLEMS

The inventors of the prevent invention have thoroughly conducted studies to find that a laminated body which is a laminate of a polyimide film having a coefficient of linear expansion in a relatively low specific range and having higher levels of heat resistance and flexibility, and an inorganic layer of a type selected from a glass plate, a ceramic plate, and a silicon wafer and having a comparable coefficient of linear expansion (for a third invention, an inorganic layer of a type selected from a glass plate, a ceramic plate, a silicon wafer, and a metal), and is excellent in heat resistance and insulation is significantly advantageous for use in production of electronic devices and the like.

Specifically, a first invention is disclosed as follows.

1. A laminated body characterized in that the laminated body is a laminate of an inorganic layer of a type selected from a glass plate, a ceramic plate, and a silicon wafer, and a polyimide film obtained by reaction between an aromatic tetracarboxylic acid and an aromatic diamine and having respective coefficients of linear expansion in a length direction and a width direction of the polyimide film that are both -5 ppm/°C to +10 ppm/°C, the inorganic layer and the polyimide film are superposed on each other without an adhesive layer between the inorganic layer and the polyimide film, and 180-degree peel strength between the polyimide film and the inorganic layer of the laminated body is not less than 0.5 N/cm and not more than 3 N/cm.
2. The laminated body according to 1, wherein the polyimide film is obtained by reaction between an aromatic tetracarboxylic acid and an aromatic diamine having a benzoxazole structure (skeleton).
3. The laminated body according to 1 or 2, wherein the polyimide film has a thickness of 1 $\mu$m to 50 $\mu$m.
4. A method of manufacturing a laminated body as recited in any of claims 1 to 3, characterized in that a surface of a polyimide film obtained by reaction between an aromatic tetracarboxylic acid and an aromatic diamine and having a coefficient of linear expansion of -5 ppm/°C to +10 ppm/°C is plasma-treated, while an inorganic layer of a type selected from a glass plate, a ceramic plate, and a silicon wafer is silane-coupling-treated, the plasma-treated surface of the polyimide film and a silane-coupling-treated surface of the inorganic layer are laid on each other, and a pressure is applied to form a laminate of the polyimide film and the inorganic layer. A second invention is disclosed as follows.
5. A laminated body formed of at least an inorganic layer and a polyimide film, wherein the laminated body is formed by attaching to each other a surface of the inorganic layer of a type selected from a glass plate, a ceramic plate, and a silicon wafer, and a surface of the polyimide film obtained by reaction between an aromatic tetracarboxylic acid and an aromatic diamine and having respective coefficients of linear expansion in a length direction and a width direction of the polyimide film that are both -5 ppm/°C to +10 ppm/°C, without an adhesive layer between the surfaces, 180-degree peel strength between the polyimide film and the inorganic layer of the laminated body is not less than 0.5 N/cm and not more than 3 N/cm, and the attached surface of the polyimide film has a surface roughness of not more than 15 nm in P-V value.
6. The laminated body according to 5, wherein a silane coupling layer is included between the inorganic layer and the polyimide film, and the silane coupling layer has a thickness of not more than 100 nm.
7. The laminated body according to 5 or 6, wherein the polyimide film is obtained by reaction between an aromatic tetracarboxylic acid and an aromatic diamine having a benzoxazole structure (skeleton).
8. The laminated body according to any of 5 to 7, wherein the polyimide film has a thickness of 1 $\mu$m to 50 $\mu$m.
9. A method of manufacturing a laminated body as recited in any of 5 to 8, formed of at least an inorganic layer and a polyimide film, wherein the polyimide film is obtained by reaction between an aromatic tetracarboxylic acid and an aromatic diamine and having respective coefficients of linear expansion at 30°C to 300°C in a length direction and a width direction of the polyimide film that are both -5 ppm/°C to +10 ppm/°C, at least one surface of the polyimide film has a surface roughness of not more than 15 nm in P-V value, the inorganic layer is of a type selected from a glass plate, a ceramic plate, and a silicon wafer and has at least one silane-coupling-treated surface, the surface having a surface roughness of not more than 15 nm in P-V value of the polyimide film, and the silane-coupling-treated surface of the inorganic layer are laid on each other, and a pressure is applied to form a laminate of the

inorganic layer and the polyimide film.

A third invention of the present application is configured as follows.

10. A laminated body formed of at least an inorganic layer and a polyimide film, characterized in that the polyimide film is obtained by reaction between an aromatic tetracarboxylic acid and an aromatic diamine having a benzoxazole structure (skeleton), a silane coupling layer is included between the inorganic layer and the polyimide film, the silane coupling layer has a thickness of not more than 100 nm, the laminated body is formed by attaching to each other a surface of the inorganic layer of a type selected from a glass plate, a ceramic plate, a silicon wafer, and a metal, and at least one said polyimide film, with the silane coupling layer between the inorganic layer and the polyimide film, respective coefficients of linear expansion in a length direction and a width direction of the polyimide film are both -4 ppm/°C to +4 ppm/°C, 180-degree peel strength between the polyimide film and the inorganic layer of the laminated body is not less than 1.5 N/cm and not more than 10 N/cm, and a non-polyimide portion penetrates in a thickness direction of the polyimide film.

11. The laminated body according to 10, wherein a value of (coefficient of linear expansion in the length direction of the inorganic layer - coefficient of linear expansion in the length direction of the polyimide film), and a value of (coefficient of linear expansion in the width direction of the inorganic layer - coefficient of linear expansion in the width direction of the polyimide film) are both -10 ppm/°C to +30 ppm/°C.

12. The laminated body according to 10 or 11, characterized in that the polyimide film has a thickness of 1 $\mu$m to 50 $\mu$m and, in the polyimide layer, at least a surface layer of 3 $\mu$m from a surface abutting on the inorganic layer contains no particle of a longer particle diameter of not less than 20 nm.

13. A laminated circuit board of a laminated body formed of at least an inorganic layer and a polyimide film, characterized in that the polyimide film is obtained by reaction between an aromatic tetracarboxylic acid and an aromatic diamine having a benzoxazole structure (skeleton), a silane coupling layer is included between the inorganic layer and the polyimide film, the silane coupling layer has a thickness of not more than 100 nm, the laminated body is formed by attaching to each other a surface of the inorganic layer of a type selected from a glass plate, a ceramic plate, a silicon wafer, and a metal, and at least one said polyimide film, with the silane coupling layer between the inorganic layer and the polyimide film, respective coefficients of linear expansion in a length direction and a width direction of the polyimide film are both -4 ppm/°C to +4 ppm/°C, and 180-degree peel strength between the polyimide film and the inorganic layer of the laminated body is not less than 1.5 N/cm and not more than 10 N/cm.

14. The laminated circuit board according to 13, characterized in that a non-polyimide portion penetrates in a thickness direction of the polyimide film in the laminated body.

15. The laminated circuit board according to 13 or 14, wherein a value of (coefficient of linear expansion in the length direction of the inorganic layer - coefficient of linear expansion in the length direction of the polyimide film), and a value of (coefficient of linear expansion in the width direction of the inorganic layer - coefficient of linear expansion in the width direction of the polyimide film) are both -10 ppm/°C to +30 ppm/°C.

16. The laminated circuit board according to any of 13 to 15, characterized in that the polyimide film has a thickness of 1 $\mu$m to 50 $\mu$m and, in the polyimide layer, at least a surface layer of 3 $\mu$m from a surface abutting on the inorganic layer contains no particle of a longer particle diameter of not less than 20 nm.

17. A method of manufacturing a laminated body as recited in any of 10 to 12, formed of at least of an inorganic layer and a polyimide film, characterized in that the polyimide film is obtained by reaction between an aromatic tetracarboxylic acid and an aromatic diamine and having respective coefficients of linear expansion in a length direction and a width direction of the polyimide film that are both -4 ppm/°C to +4 ppm/°C, at least one surface of the polyimide film has a surface roughness of not more than 15 nm in P-V value, the inorganic layer is of a type selected from a glass plate, a ceramic plate, a silicon wafer, and a metal and has at least one silane-coupling-treated surface, the surface having a surface roughness of not more than 15 nm in P-V value of the polyimide film, and the silane-coupling-treated surface of the inorganic layer are laid on each other, a pressure is applied to form a laminate of the inorganic layer and the polyimide film, and a process from the silane coupling treatment to the application of the pressure and lamination is performed in a clean room.

## EFFECTS OF THE INVENTION

A laminated body of the first invention of the present application that is a laminate of an inorganic layer of a type selected from a glass plate, a ceramic plate, and a silicon wafer, and a polyimide film obtained by reaction between an aromatic tetracarboxylic acid and an aromatic diamine and having a coefficient of linear expansion of -5 ppm/°C to +10 ppm/°C, without an adhesive layer between the inorganic layer and the polyimide film, and has 180-degree peel strength between the polyimide film and the inorganic layer of the laminated body of not less than 0.5 N/cm and not more than 3 N/cm, as well as laminated bodies of the second and third inventions of the present application having a P-V value of not more than 15 nm enable, when an electronic device is to be produced in which circuits and the like are formed on a thin film having insulation, flexibility and heat resistance and electronic components are further mounted,

precise positioning to produce multiple layers of thin films and form circuits and the like, because the thin film is superposed on and secured to the inorganic substrate of excellent dimensional stability. Further, when the inorganic substrate is to be peeled off after device production, the laminated body has a peel strength that enables the film and the substrate from being smoothly peeled off from each other and prevents peeling during the process. Therefore, the conventional electronic device production process can be used as it is, and the device on the film can be produced stably and precisely. The laminated bodies are extremely advantageous for production of electronic devices and the like in which circuits and the like are formed on a thin film with insulation, flexibility and heat resistance.

BEST MODES FOR CARRYING OUT THE INVENTION

The type of the polyimide in the polyimide film in the laminated body of the present invention is not particularly limited, as long as the polyimide film is obtained by reaction between an aromatic tetracarboxylic acid and an aromatic diamine, and has a coefficient of linear expansion (in both of the length direction and the width direction of the film) of -5 ppm/°C to +10 ppm/°C. The polyimide film is obtained by a method according to which an aromatic tetracarboxylic acid (anhydrides, acids, and amido-bond derivatives thereof are collectively referred to as "aromatic tetracarboxylic acid", the same is applied as well hereinafter) and an aromatic diamine (amines and amido-bond derivatives thereof are collectively referred to as "aromatic diamine", the same is applied as well hereinafter) are reacted with each other to generate a polyamide acid solution that is then cast, dried, and heat-treated (imidized) to form a film. A solvent used for the solution may be N-methyl-2-pyrrolidone, N,N-dimethylformamide, N,N-dimethylacetamide, or the like.

Preferred examples of the polyimide in the present invention may be the following combinations of aromatic diamines and aromatic tetracarboxylic acids (anhydrides):

A. a combination of an aromatic tetracarboxylic acid having a pyromellitic acid residue, and an aromatic diamine having a benzoxazole structure (skeleton); and

B. a combination of an aromatic diamine having a phenylene diamine skeleton, and an aromatic tetracarboxylic acid having a biphenyl tetracarboxylic acid skeleton.

In particular, combination A of the polyimide including the aromatic diamine residue having the benzoxazole structure is preferred.

The molecular structure of the aromatic diamine having the benzoxazole structure is not particularly limited. Specific examples are as follows.

Formula 1

5-amino-2-(p-aminophenyl)benzoxazole

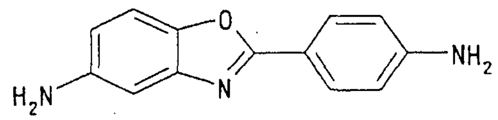

Formula 2

6-amino-2-(p-aminophenyl)benzoxazole

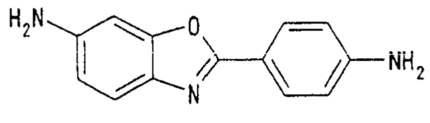

Formula 3

5-amino-2-(m-aminophenyl)benzoxazole

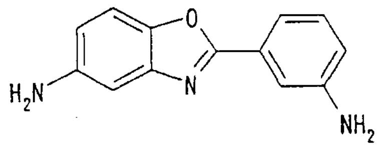

Formula 4

6-amino-2-(m-aminophenyl)benzoxazole

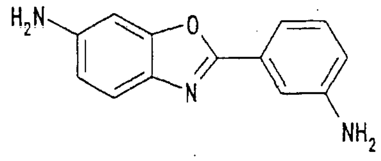

Formula 5

2,2'-p-phenylenebis(5-aminobenzoxazole)

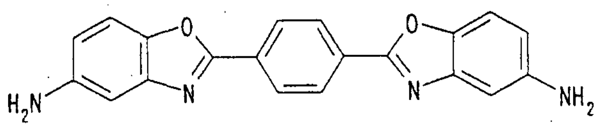

Formula 6

2,2'-p-phenylenebis(6-aminobenzoxazole)

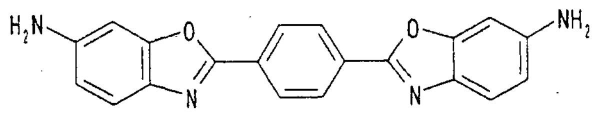

Formula 7

1-(5-aminobenzoxazolo)-4-(6-aminobenzoxazolo)benzene

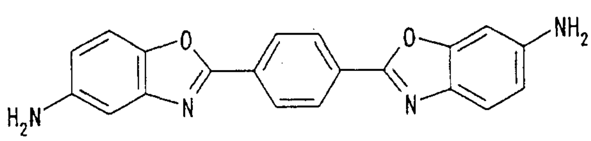

Formula 8

2,6-(4,4'-diaminodiphenyl)benzo[1,2-d:5,4-d']bisoxazole

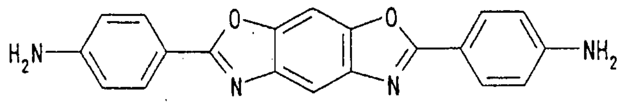

Formula 9

2,6-(4,4'-diaminodiphenyl)benzo[1,2-d:4,5-d']bisoxazole

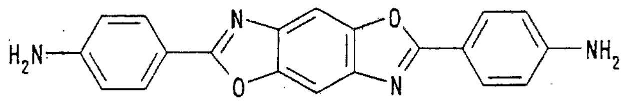

Formula 10

2,6-(3,4'-diaminodiphenyl)benzo[1,2-d:5,4-d']bisoxazole

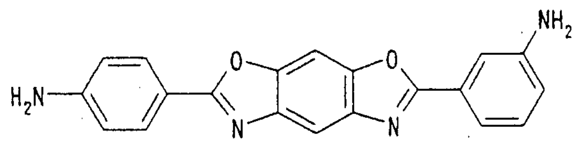

Formula 11

2,6-(3,4'-diaminodiphenyl)benzo[1,2-d:4,5-d']bisoxazole

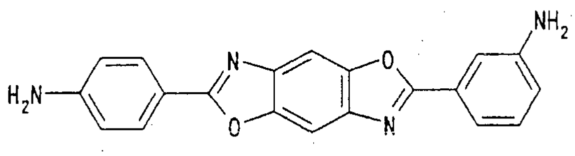

Formula 12

2,6-(3,3'-diaminodiphenyl)benzo[1,2-d:5,4-d']bisoxazole

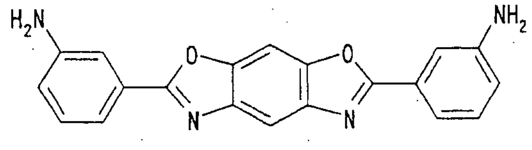

Formula 13

2,6-(3,3'-diaminodiphenyl)benzo[1,2-d:4,5-d']bisoxazole

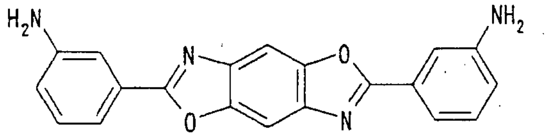

Among them, in terms of easiness of synthesis, each isomer of amino(aminophenyl)benzoxazole is preferred, and 5-amino-2-(p-aminophenyl)benzoxazole is more preferred. Here, "each isomer" refers to each isomer in which two amino groups of the amino(aminophenyl)benzoxazole are determined in accordance with the position in the configuration (for example, respective compounds represented by "Formula 1" to "Formula 4" above). These diamines may be used singly or in combination of two or more of them.

In the present invention, one of or two or more of diamines exemplarily listed below may be used in combination as long as the diamine or diamines is/are not more than 30 mol% relative to the whole diamines. Such diamines include, for example, 4,4'-bis (3-aminophenoxy)biphenyl, bis[4-(3-aminophenoxy)phenyl]ketone, bis[4-(3-aminophenoxy)phenyl]sulfide, bis[4-(3-aminophenoxy)phenyl]sulfone, 2,2-bis[4-(3-aminophenoxy)phenyl]propane, 2,2-bis[4-(3-aminophenoxy)phenyl]-1,1,1,3,3,3-hexafluoropropane, m-phenylenediamine, o-phenylenediamine, p-phenylenediamine, m-aminobenzylamine, p-aminobenzylamine, 3,3'-diaminodiphenyl ether, 3,4'-diaminodiphenyl ether, 4,4'-diaminodiphenyl ether, 3,3'-diaminodiphenyl sulfide, 3,3'-diaminodiphenyl sulfoxide, 3,4'-diaminodiphenyl sulfoxide, 4,4'-diaminodiphenyl sulfoxide, 3,3'-diaminodiphenyl sulfone, 3,4'-diaminodiphenyl sulfone, 4,4'-diaminodiphenyl sulfone, 3,3'-diaminobenzophenone, 3,4'-diaminobenzophenone, 4,4'-diaminobenzophenone, 3,3'-diaminodiphenylmethane, 3,4'- diaminodiphenylmethane, 4,4'-diaminodiphenylmethane, bis[4-(4-aminophenoxy)phenyl]methane, 1,1-bis[4-(4-aminophenoxy)phenyl]ethane, 1, 2-bis[4-(4-aminophenoxy)phenyl]ethane, 1,1-bis[4-(4-aminophenoxy)phenyl]propane, 1,2-bis[4-(4-aminophenoxy)phenyl]propane, 1,3-bis[4-(4-aminophenoxy)phenyl]propane, 2,2-bis[4-(4-aminophenoxy)phenyl]propane, 1,1-bis[4-(4-aminophenoxy)phenyl]butane, 1,3-bis[4-(4-aminophenoxy)phenyl]butane, 1,4-bis[4-(4-aminophenoxy)phenyl]butane, 2,2-bis[4-(4-aminophenoxy)phenyl]butane, 2,3-bis[4-(4-aminophenoxy)phenyl]butane, 2-[4-(4-aminophenoxy)phenyl]-2-[4-(4-aminophenoxy)-3-methylphenyl]propane, 2,2-bis[4-(4-aminophenoxy)-3-methylphenyl]propane, 2-[4-(4-aminophenoxy)phenyl]-2-[4-(4-aminophenoxy)-3,5-dimethylphenyl]propane, 2,2-bis[4-(4-aminophenoxy)-3,5-dimethylphenyl]propane, 2,2-bis[4-(4-aminophenoxy)phenyl]-1,1,1,3,3,3-hexafluoropropane, 1,4-bis(3-aminophenoxy)benzene, 1,3-bis(3-aminophenoxy)benzene, 1,4-bis(4-aminophenoxy)benzene, 4,4'-bis(4-aminophenoxy)biphenyl, bis[4-(4-aminophenoxy)phenyl]ketone, bis[4-(4-aminophenoxy)phenyl]sulfide, bis[4-(4-aminophenoxy)phenyl]sulfoxide, bis[4-(4-aminophenoxy)phenyl]sulfone, bis[4-(3-aminophenoxy)phenyl]ether, bis[4-(4-aminophenoxy)phenyl]ether, 1,3-bis[4-(4-aminophenoxy)benzoyl]benzene, 1,3-bis[4-(3-aminophenoxy)benzoyl]benzene, 1,4-bis[4-(3-aminophenoxy)benzoyl]benzene, 4,4'-bis[(3-aminophenoxy)benzoy]]benzene, 1,1-bis[4-(3-arainophenoxy)phenyl]propane, 1,3-bis[4-(3-aminophenoxy)phenyl]propane, 3,4'-diaminodiphenyl sulfide, 2,2-bis[3-(3-aminophenoxy)phenyl]-1,1,1,3,3,3-hexafluoropropane, bis[4-(3-aminophenoxy)phenyl]methane, 1,1-bis[4-(3-aminophenoxy)phenyl]ethane, 1,2-bis[4-(3-aminophenoxy)phenyl]ethane, bis[4-(3-aminophenoxy)phenyl]sulfoxide, 4,4'-bis[3-(4-aminophenoxy)benzoyl]diphenyl ether, 4,4'-bis[3-(3-aminophenoxy)benzoyl]diphenyl ether, 4,4'-bis[4-(4-amino-α,α-dimethylbenzyl)phenoxy]benzophenone, 4,4'-bis[4-(4-amino-α,α-dimethylbenzyl)phenoxy]diphenyl sulfone, bis[4-{4-(4-aminophenoxy)phenoxy}phenyl]sulfone, 1,4-bis[4-(4-aminophenoxy)phenoxy-α,α-dimethylbenzyl]benzene, 1,3-bis[4-(4-aminophenoxy)phenoxy-α,α-dimethylbenzyl]benzene, 1,3-bis[4-(4-amino-6-trifluoromethyl phenoxy)-α,α-dimethylbenzyl]benzene, 1,3-bis[4-(4-amino-6-fluorophenoxy)-α,α-dimethylbenzyl]benzene, 1,3-bis[4-(4-amino-6-methylpheonoxy)-α,α,-dimethylbenzyl]benzene, 1,3-bis[4-(4-amino-6-cyanophenoxy)-α,α-dimethylbenzyl]benzene, 3,3'-diamino-4,4'-diphenoxybenzophenone, 4,4'-diamino-5,5'-diphenoxybenzophenone, 3,4'-diamino-4,5'-diphenoxybenzophenone, 3,3'-diamino-4-phenoxybenzophenone, 4,4'-diamino-5-phenoxybenzophenone, 3,4'-diamino-4-phenoxybenzophenone, 3,4'-diamino-5'-phenoxybenzophenone, 3,3'-diamino-4,4'-dibiphenoxybenzophenone, 4,4'-diamino-5,5'-dibiphenoxybenzophenone, 3,4'-diamino-4,5'-dibiphenoxybenzophenone, 3,3'-diamino-4-biphenoxybenzophenone, 4,4'-diamino-5-biphenoxybenzophenone, 3,4'-diamino-4-biphenoxybenzophenone, 3,4'-diamino-5'-biphenoxybenzophenone, 1,3-bis(3-amino-4-phenoxybenzoyl)benzene, 1,4-bis(3-amino-4-phenoxybenzoyl)benzene, 1,3-bis(4-amino-5-phenoxybenzoyl)benzene, 1,4-bis(4-amino-5-phenoxybenzoyl)benzene, 1,3-bis(3-amino-4-biphenoxybenzoyl)benzene, 1,4-bis(3-amino-4-biphenoxybenzoyl)benzene, 1,3-bis(4-amino-5-biphenoxybenzoyl)benzene, 1,4-bis(4-amino-5-biphenoxybenzoyl)benzene, 2,6-bis[4-(4-amino-a,a-dimethylbenzyl)phenoxy]benzonitrile, and the above aromatic diamines in which a part or all of hydrogen atoms on the aromatic ring is/are substituted with halogen atoms, alkyl group or alkoxyl group of carbon number 1 to 3, cyano group, or alkyl halide or alkoxyl halide in which a part or all

of hydrogen atoms of alkyl group or alkoxyl group is/are substituted with halogen atoms, and the like.

<Aromatic tetracarboxylic acid anhydrides>

Specific examples of aromatic tetracarboxylic acid anhydrides used for the present invention are as follows.

Formula 14

pyromellitic acid anhydride

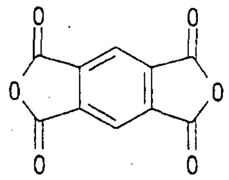

Formula 15

3,3',4,4'-biphenyl tetracarboxylic acid anhydride

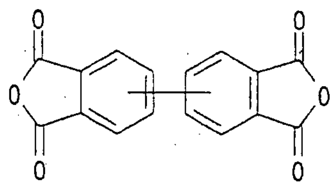

Formula 16

4,4'-oxydiphthalic acid anhydride

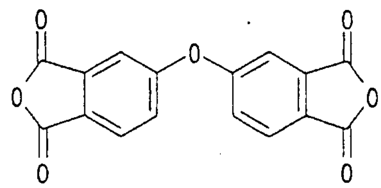

Formula 17

3,3',4,4'-benzophenone tetracarboxylic acid anhydride

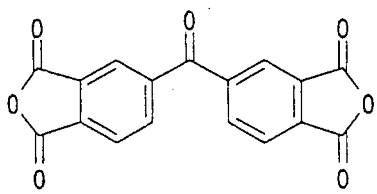

Formula 18

3,3',4,4'-diphenyl sulfone tetracarboxylic acid anhydride

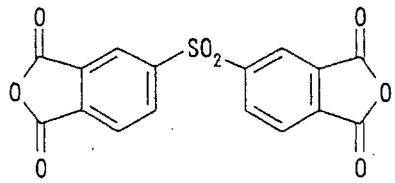

Formula 19

2,2-bis[4-(3,4-dicarboxyphenoxy)phenyl]propanoic acid anhydride

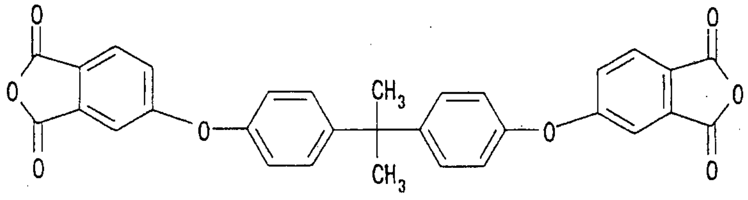

These tetracarboxylic acid dianhydrides may be used singly or in combination of two or more of them.

A solvent used when an aromatic tetracarboxylic acid and an aromatic diamine are reacted (polymerized) to obtain a polyamide acid is not particularly limited, as long as the solvent dissolves both of the material monomers and the generated polyamide acid. A polar organic solvent is preferred, such as, for example, N-methyl-2-pyrrolidone, N-acetyl-2-pyrrolidone, N,N-dimethylformamide, N,N-diethylformamide, N,N-dimethylacetamide, dimethyl sulfoxide, hexamethylphosphoric amide, ethyl cellosolve acetate, diethylene glycol dimethyl ether, sulfolane, and phenol halide. These solvents may be used singly or mixed for use. As to the amount of the solvent to be used, the amount may be any as long as the amount is sufficient to dissolve material monomers. A specific amount is, by the weight of monomers relative to the solution in which monomers are dissolved, usually 5 to 40 wt%, and preferably 10 to 30 wt%.

Conditions for polymerization reaction for obtaining a polyamide acid (hereinafter simply referred to as "polymerization reaction") may be conventionally known conditions. A specific example is agitating and/or mixing in an inorganic solvent at a temperature range of 0 to 80°C continuously for 10 minutes to 30 hours. The polymerization reaction may be divided, or the temperature may be increased and decreased, as required. In this case, the order in which the two monomers are added is not particularly limited. Preferably, to a solution of an aromatic diamine, an aromatic tetracarboxylic acid anhydride is added. The weight of the polyamide acid relative to the solution of the polyamide acid obtained by polymerization reaction is preferably 5 to 40 wt%, and more preferably 10 to 30 wt%. The viscosity of the solution measured by a Brookfield viscometer (250°C) is, in terms of liquid feed stability, preferably 10 to 2000 Pa·s, and more preferably 100 to 1000 Pa·s.

Vacuum defoaming during polymerization reaction is effective for manufacture of a high-quality polyamide acid solution. Further, polymerization may be controlled by adding a small amount of an end sealant to an aromatic diamine before polymerization reaction. An example of the end sealant is a compound having a carbon-carbon double bond such as maleic anhydride. When maleic anhydride is used, the amount thereof to be used is preferably 0.001 to 1.0 mol per mol of an aromatic diamine.

In order to form a polyimide film from a polyamide acid solution obtained by polymerization reaction, a method may be such that the polyamide acid solution is applied onto a support and dried to obtain a green film (self-supporting precursor film), and then, the green film is heat-treated for imidization reaction. Application of the polyamide acid solution to the support includes casting from a fitting with a slit, extrusion from an extruder and the like. The application is not limited to them, and conventionally known solution application means may appropriately be used.

For the polyimide film of the present invention, preferably a lubricant is added into the polyimide to form fine protrusions and depressions on the surface of the layer (film) so that the adhesiveness and the like of the layer (film) is improved. As the lubricant, inorganic or organic fine particles having an average size of approximately 0.03 μm to 0.8 μm may be used. Specific examples are titanium oxide, alumina, silica, calcium carbonate, calcium phosphate, calcium

hydrogen phosphate, calcium pyrophosphate, magnesium oxide, calcium oxide, clay mineral, and the like.

It is necessary that these fine particles in a range of 0.20 to 2.0 mass% are contained in the film. The content of the fine particles of less than 0.20 mass% is not preferred, because improvement of the adhesiveness is less than satisfactory. When the content exceeds 2.0 mass%, the protrusions and depressions on the surface are too large, leaving a problem that smoothness is deteriorated in contrast to improvement if any of the adhesiveness, and such a content is not preferred.

In order to reduce the thickness of an adhesive layer which will be described below, it is desired that the particle size of the lubricant is substantially comparable to or less than the thickness of the adhesive layer. It should be noted that, in the polyimide layer, a portion of at least 3 μm on the side abutting on the inorganic layer includes no particle with a longer particle diameter of not less than 20 nm. Therefore, the side of the polyimide layer that abuts on the inorganic layer is smooth, the contact probability in terms of atomic level with the smooth inorganic layer is increased, which is appropriate for adhesion. Still preferably, in the polyimide layer, a portion of not less than 5 μm on the side abutting on the inorganic layer includes no particle with a longer particle diameter of not less than 20 nm.

The thickness of the polyimide film of the present invention is not particularly limited. The thickness is preferably 1 μm to 50 μm, and more preferably 39 μm to 3 μm. The unevenness in thickness of these films is preferably not more than 20%. When the thickness is less than 1 μm, control of the thickness is difficult, resulting in difficulty in peeling the film off from the inorganic layer. When the thickness is not less than 50 μm, the film is difficult to produce, and the film is likely to be bent when peeled. These films can be used to significantly contribute to enhancement of the performance of the device such as sensor and reduction in weight and size of an electronic component.

Regarding the first and second inventions of the present application, the polyimide film has an average coefficient of linear expansion from 30 to 300°C of -5 ppm/°C to +10 ppm/°C, and preferably -3 ppm/°C to +5 ppm/°C. Regarding the third invention of the present application, the polyimide film has an average coefficient of linear expansion from 30 to 300°C of -4 ppm/°C to +4 ppm/°C, and preferably -2 ppm/°C to +3 ppm/°C. When the coefficient is out of these ranges, the difference in coefficient of linear expansion between the polyimide film and the inorganic substrate is large so that the film and the inorganic layer are likely to be peeled off from each other during a heating process, resulting in difficulty in use.

The silane coupling agent of the present invention is not particularly limited. Preferably the silane coupling agent has an amino group or epoxy group. Specific examples of the silane coupling agent include N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-aminopropyltriethoxysilane, 3-triethoxysilyl-N-(1,3-dimethyl-butylidene)propylamine, 2-(3,4-epoxycyclohexyl)ethyltrimethoxysilane, 3-glycidoxypropyltrimethoxysilane, 3-glycidoxypropylmethyldiethoxysilane, 3-glycidoxypropyltriethoxysilane, vinyltrichlorosilane, vinyltrimethoxysilane, vinyltriethoxysilane, 2-(3,4-epoxycyclohexyl)ethyltrimethoxysilane, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, N-phenyl-3-aminopropyltrimethoxysilane, N-(vinyl benzyl)-2-aminoethyl-3-aminopropyltrimethoxysilane hydrochloride, 3-ureidepropyltriethoxysilane, 3-chloropropyltrimethoxysilane, 3-mercaptopropylmethyldimethoxysilane, 3-mercaptopropyltrimethoxysilane, bis(triethoxysilylpropyl)tetrasulfide, 3-isocyanatepropyltriethoxysilane, tris-(3-trimethoxysilylpropyl)isocyanurate, and the like.

Among them, preferred examples are N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-aminopropyltriethoxysilane, 3-triethoxysilyl-N-(1,3-dimethyl-butylidene)propylamine, 2-(3,4-epoxycyclohexyl)ethyltrimethoxysilane, 3-glycidoxypropyltrimethoxysilane, 3-glycidoxypropylmethyldiethoxysilane, 3-glycidoxypropyltriethoxysilane, aminophenyltrimethoxysilane, aminophenethyltrimethoxysilane, aminophenylaminomethylphenethyltrimethoxysilane, and the like.

Examples of the silane-coupling-agent treatment method of the present invention may be a method according to which a solution of a coupling agent is applied to a base, dried, and heat-treated, and a method according to which the agent is added when the polyimide film is produced and the coupling-agent treatment is performed simultaneously with the film production.

The glass plate of the present invention includes silica glass, high-silica glass (96% silica), soda-lime glass, lead glass, aluminoborosilicate glass, borosilicate glass (Pyrex®), borosilicate glass (non alkali), borosilicate glass (microsheet), and aluminosilicate glass. In particular, those having a coefficient of linear expansion of not more than 5 ppm/°C are desired, and Corning's 1753, AN100 of Asahi Glass Co., Ltd. for liquid crystal glass, for example, are desired.

The ceramic plate of the present invention includes ceramic materials for a substrate such as $Al_2O_3$, mullite, AlN, SiC, crystallized glass, cordierite, spodumene, Pb-BSG + $CaZrO_3$ + $Al_2O_3$, crystallized glass + $Al_2O_3$, crystallized Ca-BSG, BSG + quartz, BSG + quartz, BSG + $Al_2O_3$, Pb-BSG + $Al_2O_3$, glass-ceramic, Zerodur material, and the like.

The silicon wafer of the present invention includes an n-type or p-type doped silicon wafer, and all intrinsic silicon wafers, and further includes silicon wafers having a surface on which a silicon oxide layer or any of various types

of thin films is superposed.

In addition to the silicon wafers, germanium, silicon-germanium, gallium-arsenic, aluminum-gallium-indium, and nitrogen-phosphorus-arsenic-antimony are frequently used. General-purpose semiconductor wafers such as InP (indium phosphide), InGaAs, GaInNAs, LT, LN, ZnO (zinc oxide), and CdTe (cadmium telluride), ZnSe (zinc selenide) and the like are included.

The metal for the third invention of the present application includes single-element metals such as W, Mo, Pt, Fe, Ni, Au, and alloys such as Inconel, Monel, Nimonic, carbon-copper, Fe-Ni-based Invar alloy, super Invar alloy. It also includes multilayer metal plates in which, to the above-described metals, other metal layers and ceramic layers are added. In this case, if the CTE of the whole with the additional layer is low, Cu, Al and the like may also be used for the main metal layer. The metals used for the additional metal layers are not particularly limited, as long as the metals strengthen adhesion with the polyimide film, have no dispersion, and have properties such as good chemical resistance and heat resistance. Preferred examples may include chromium, nickel, TiN, Mo-contained Cu.

The plasma treatment for the present invention is not particularly limited, and includes RF plasma treatment in vacuum, microwave plasma treatment, atmospheric pressure plasma treatment, corona treatment and the like, and also includes gas treatment including fluorine, ion implantation treatment using an ion source, treatment using the PBII method, flame treatment, itro treatment, and the like. In particular, RF plasma treatment in vacuum, microwave plasma treatment, and atmospheric pressure plasma treatment are preferred.

The method for applying a pressure for the present invention may be ordinary pressing in atmosphere or pressing in vacuum. In order to obtain a stable peel strength over the whole surface, pressing in vacuum is preferred. As to the degree of vacuum, a vacuum generated by an ordinary oil rotary pump is sufficient, and a vacuum of not more than approximately 10 Torr is sufficient. A preferred pressure for pressing a sample is from 1 MPa to 20 MPa, and more preferably from 3 to 10 MPa.

A higher pressure could break the substrate, while a lower pressure may leave a portion without adhesion. A preferred temperature is from 150°C to 400°C, and more preferably from 250°C to 350°C. A higher temperature damages the film, while a lower temperature causes weak adhesion.

A lamination method for the laminated body of the first and second inventions of the present application is not particularly limited. The laminated body is a laminate of an inorganic layer of a type selected from a glass plate, a ceramic plate, and a silicon wafer (for the third invention of the present application, an inorganic layer of a type selected from a glass plate, a ceramic plate, a silicon wafer, and a metal), and a polyimide film obtained by reaction between an aromatic tetracarboxylic acid and an aromatic diamine and having a coefficient of linear expansion of -5 ppm/°C to +10 ppm/°C (for the third invention of the present application, -4 ppm/°C to +4 ppm/°C), without adhesive layer provided therebetween, and 180-degree peel strength between the polyimide film and the inorganic layer of the laminated body is not less than 0.5 N/cm and not more than 3 N/cm (for the third invention of the present application, the 180-degree peel strength is not less than 1.5 N/cm and not more than 10 N/cm). Preferably, a surface of the polyimide film obtained by reaction between an aromatic tetracarboxylic acid and an aromatic diamine and having the above-described coefficient of linear expansion is plasma-treated, while the inorganic layer of a type selected from a glass plate, a ceramic plate, and a silicon wafer is silane-coupling-treated, the plasma-treated surface of the polyimide film and the silane-coupling-treated surface of the inorganic layer are laid on each other, and they are vacuum-pressed to form a laminate. Regarding the second and third inventions of the present application, a surface of the polyimide film that has a surface roughness of not more than 15 nm and more preferably not more than 10 nm in P-V value is laid on the inorganic layer so that they more closely fit with each other. Because it is difficult to produce and maintain a polyimide film in which a surface to be attached has a surface roughness of 2 nm or less in P-V value, the attached surface of the polyimide film substantially has a surface roughness of not less than 2 nm in P-V value.

A glass plate, ceramic plate, or silicon wafer having a coefficient of linear expansion of approximately 0 ppm/°C to +5 ppm/°C, and a polyimide film having a coefficient of linear expansion of -5 ppm/°C to +10 ppm/°C can be superposed on each other to have almost no difference in coefficient of linear expansion between them, and therefore, when an electronic device is produced on the film superposed on the inorganic substrate which is subjected to a high temperature, the film and the inorganic layer are not peeled off from each other and distortion of the film does not occur, and the device can be precisely produced. Regarding the first and second inventions of the present application, the 180-degree peel strength between the inorganic substrate and the polyimide film is not less than 0.5 N/cm and not more than 3 N/cm. Therefore, peeling does not occur under heat and stress in the device production process, and no unreasonable force is required for peeling off the inorganic substrate, and the device can be produced stably. Regarding the third invention of the present application, preferably the 180-degree peel strength between the inorganic substrate and the polyimide film is not less than 1.5 N/cm and not more than 10 N/cm. With the 180-degree peel strength of preferably not less than 1.5 N/cm, more preferably not less than 2 N/cm, and more preferably not less than 3 N/cm, no peeling occurs under heat and stress in the device production process. Further, with the 180-degree peel strength of not more than 10 N/cm, preferably not more than 5 N/cm, and more preferably not more than 3 N/cm, the polyimide film can also be peeled off to be used without accumulation of unreasonable stress. The device can stably be produced. Moreover, because

the presence of foreign matters influences the peel strength, it is effective for improvement of the 180-degree peel strength to employ a method of performing the process from application and drying of the silane coupling agent, and plasma treatment of the film, superposition of the film, to the vacuum pressing preferably in a clean room, and more preferably in a clean room of class 1000 so as to prevent attachment of foreign matters, or a method of using a spin coater in advance to wash the substrate with an organic solvent such as ethanol so as to remove attached foreign matters.

Between the inorganic layer and the polyimide film of the present invention, a layer having a composition different from respective compositions of the inorganic layer and the polyimide layer is present, however, there is no adhesive layer. For the present invention, an adhesive layer refers to the one having an Si content ratio by weight of not more than 15%. Further, those having a distance between the inorganic layer and the polyimide film of not less than 0.4 μm do not belong to the present invention. Only those including Si which is derived from a silane coupling agent and is of a content of not less than 10% by weight belong to the present invention. A layer of a silane coupling agent can be used to make the intermediate layer thinner. Therefore, the effects of less outgas components during heating, less dissolving even in a wet process, and a trace of dissolving if dissolving occurs are obtained. It should be noted that the layer derived from the silane coupling agent has a high content of silicon oxide with heat resistance and has heat resistance at a temperature of approximately 400°C, and is less than 0.4 μm, and approximately not more than approximately 0.2 μm when produced in an ordinary manner, and the range to be used is not more than 100 nm (not more than 0.1 μm), preferably not more than 50 nm, and more preferably 10 nm. In a process in which the silane coupling agent of an amount as small as possible is desired, the one of not more than 5 nm can also be used. In the case of not more than 1 nm, the peel strength decreases, or a partially non-attached portion could be left, and it is preferably not less than 1 nm.

EXAMPLES

In the following, the present invention will more specifically be described using examples and comparative examples. The present invention, however, is not limited to the following examples. The method for evaluating properties in the following examples is as follows.

1. Reduced viscosity of polyamide acid (ηsp/C)

A solution in which a polymer was dissolved in N-methyl-2-pyrrolidone (or N,N-dimethylacetamide) so that the polymer concentration was 0.2 g/dl was measured with an Ubbelohde-type viscometer tube at 30°C. (In the case where the solvent used for preparation of a polyamide acid solution was N,N-dimethylacetamide, the N,N-dimethylacetamide was used to dissolve a polymer and the measurement was taken.)

2. Thickness of polyimide film and others

The thickness was measured by means of a micrometer (manufactured by FeinPruf Perthen GmbH, Millitron 1245D).

3. Tensile elastic modulus, tensile rupture strength, and tensile rupture elongation of polyimide film

A polyimide film to be measured was cut along the flow direction (MD direction) and the width direction (TD direction) into strips that were each 100 mm × 10 mm, and the strips were used as specimens. A tension tester (manufactured by Shimadzu Corporation, Autograph (R), model name AG-5000A) was used and, under the conditions of a tension speed of 50 mm/min and a chuck to chuck distance of 40 mm, the tensile elastic modulus, tensile rupture strength, and tensile rupture elongation were measured each for the MD direction and the TD direction.

4. 180-degree peel strength

In accordance with the 180-degree peel method of JIS C6471, the peel strength of specimens was determined by conducting a 180-degree peel test under the following conditions.

Apparatus's name: Autograph AG-IS manufactured by Shimadzu Corporation
Temperature for measurement: room temperature
Peel speed: 50 mm/min
Ambient: atmosphere
Measurement sample width: 1 cm

5. Coefficient of linear expansion (CTE)

For a polyimide film to be measured, the elasticity rate was measured for the flow direction (MD direction) and the width direction (TD direction) under the following conditions, the elasticity rate/temperature was measured for every 15°C, specifically for 30° to 45°C, 45° to 60°C, ... up to 300°C, and the average of all measurements was calculated to be used as CTE.

Name of the machine: TMA4000S manufactured by Mac Sciences Ltd.
Length of specimen: 20 mm
Width of specimen: 2 mm
Initial load: 34.5 g/mm$^2$
Initial temperature: 25°C
Final temperature: 400°C
Rate of temperature increase: 5°C/min
Ambient: argon

6. Measurement of PV value

For measurement of the surface form, a scan-type probe microscope having a surface property evaluation capability (manufactured by SII Nanotechnology Inc., SPA300/SPI3800N) was used. The measurement was performed in a DFM.mode and, as a cantilever, DF3 or DF20 manufactured by SII Nanotechnology Inc., was used. As a scanner, FS-20A was used, the scan range was 2 μm × 2 μm, and the measurement resolution was set to 512 × 512 pixels. For a measurement image, a secondary tilt correction was made, and thereafter the PV value was calculated by means of software provided to the machine.

7. Method of measuring thickness of silane coupling agent layer

As the thickness of a silane coupling agent layer, the thickness of a film formed on an Si wafer was measured.
As the method of measuring the film thickness, ellipsometry was used, and FE-5000 manufactured by Photal was used as a measuring device. Hardware specifications of the measuring device are as follows.

Range of reflection angle: from 45 to 80°
Range of wavelengths: from 250 to 800 nm
Wavelength resolution: 1.25 nm
Spot size: 1 mm
Tan ψ measurement accuracy: ±0.01
CosΔ measurement accuracy: ±0.01
Method: rotating analyzer method

Measurement was performed at a deflector angle of 45°, incident light was fixed at 70°, the analyzer was set at every 11.25° from 0 to 360° and for 250 to 800 nm.
Fitting by nonlinear least square was used to determine the film thickness. At this time, the model was an air/thin film/Si model, and expressions

$$n = C_3 / \lambda^4 + C_2 / \lambda^2 + C_1$$

$$k = C_6 / \lambda^4 + C_5 / \lambda^2 + C_4$$

were used to determine wavelength dependencies $C_1$ to $C_6$.

[Reference Example 1]

(Preliminary dispersion of inorganic particles)

1.22 parts by mass of spherical particles of amorphous silica, Seahostar KE-P10 (manufactured by Nippon

Shokubai Co., Ltd.) and 420 parts by mass of N-methyl-2-pyrrolidone were fed into a vessel having a liquid-contact portion and a liquid-conveying pipe that are made of austenite-based stainless steel SUS316L, and agitated by a homogenizer T-25 basic (manufactured by IKA Labortechnik) at a revolution speed of 1000 revolutions/min for one minute to obtain a preliminary dispersion liquid. The average particle size in the preliminary dispersion liquid was 0.11 μm.

(Preparation of polyamide acid solution)

The inside of a reaction vessel provided with a nitrogen feed pipe, a temperature gauge, and an agitator rod and having a liquid-contact portion and a liquid-conveying pipe of austenite-based stainless steel SUS316L was replaced with nitrogen, and thereafter 223 parts by mass of 5-amino-2-(p-aminophenyl)benzoxazole was fed into the vessel. Then, 4000 parts by mass of N-methyl-2-pyrrolidone was added and dissolved completely. After this, 420 parts by mass of the preliminary dispersion liquid having been obtained in advance and 217 parts by mass of pyromellitic acid dianhydride were added and agitated at 25°C for 24 hours. Then, a brown viscous polyamide solution A was obtained. The reduced viscosity (ηsp/C) was 3.8.

[Reference Example 2]

(Preliminary dispersion of inorganic particles).

3.7 parts by mass of spherical particles of amorphous silica, Seahostar KE-P10 (manufactured by Nippon Shokubai Co., Ltd.) and 420 parts by mass of N-methyl-2-pyrrolidone were fed into a vessel having a liquid-contact portion and a liquid-conveying pipe that are made of austenite-based stainless steel SUS316L, and agitated by a homogenizer T-25 basic (manufactured by IKA Labortechnik) at a revolution speed of 1000 revolutions/min for one minute to obtain a preliminary dispersion liquid.

(Preparation of polyamide acid solution)

The inside of a reaction vessel provided with a nitrogen feed pipe, a temperature gauge, and an agitator rod and having a liquid-contact portion and a liquid-conveying pipe of austenite-based stainless steel SUS316L was replaced with nitrogen, and thereafter 108 parts by mass of phenylenediamine was fed into the vessel. Then, 3600 parts by mass of N-methyl-2-pyrrolidone was added and dissolved completely. After this, 420 parts by mass of the preliminary dispersion liquid having been obtained in advance and 292.5 parts by mass of biphenyl tetracarboxylic acid dianhydride were added and agitated at 25°C for 12 hours. Then, a brown viscous polyamide solution B was obtained. The reduced viscosity (ηsp/C) was 4.5.

[Production Examples 1 and 2]

(Preparation of polyamide acid solutions A1 and A2)

The inside of a reaction vessel provided with a nitrogen feed pipe, a temperature gauge, and an agitator rod was replaced with nitrogen, and thereafter 223 parts by mass of 5-amino-2-(p-aminophenyl)benzoxazole and 4416 parts by mass of N,N-dimethylacetamide were added and dissolved completely. After this, 217 parts by mass of pyromellitic acid dianhydride was added and Snowtex (DMAC-ST30 manufactured by Nissan Chemical) in which colloidal silica was dispersed in dimethylacetamide was added so that the amount of silica was the one indicated in Table 1, and they were agitated at a reaction temperature of 25°C for 24 hours to obtain brown viscous polyamide acid solutions A1 and A2.

Table 1

| | unit | Production Example 1 | Production Example 2 |
|---|---|---|---|
| polyamide acid solution | | A1 | A2 |
| type of lubricant | | - | Silica |
| particle size of lubricant | μm | - | 0.08 |
| amount of added lubricant | mass% | 0 | 0.7 |

[Production Examples 3 and 4]

(Preparation of polyamide acid solutions B1 and B2)

The inside of a reaction vessel provided with a nitrogen feed pipe, a temperature gauge, and an agitator rod was replaced with nitrogen, and thereafter 1,3-bis(4-aminophenoxy)benzene (BPDA) was fed and N,N-dimethylacetamide was supplied, and they were well agitated to become uniform. After this, pyromellitic acid dianhydride (PMDA) equivalent to BPDA was fed, Snowtex (DMAC-ST30 manufactured by Nissan Chemical) in which colloidal silica was dispersed in dimethylacetamide were added so that the amount of silica was the one indicated in Table 2, and they were agitated at a reaction temperature of 25°C for 24 hours to obtain brown viscous polyamide acid solutions B1 and B2.

[Production Example 5]

(Preparation of polyamide acid solution C)

The inside of a reaction vessel provided with a nitrogen feed pipe, a temperature gauge, and an agitator rod was replaced with nitrogen, and thereafter equivalent pyromellitic acid dianhydride (PMDA) and 4,4' diaminodiphenylether (ODA) were fed and dissolved in N,N-dimethylacetamide, Snowtex (DMAC-ST30 manufactured by Nissan Chemical) in which colloidal silica was dispersed in dimethylacetamide was added so that the amount of silica was the one indicated in Table 2, and agitated at a reaction temperature of 25°C for 24 hours to obtain a brown viscous polyamide acid solution C.

Table 2

| | unit | Production Example 3 | Production Example 4 | Production Example 5 |
|---|---|---|---|---|
| polyamide acid solution | | B1 | B2 | C |
| type of lubricant | | - | silica | - |
| particle size of lubricant | μm | - | 0.08 | - |
| amount of added lubricant | mass% | 0 | 0.7 | 0 |

[Formation of polyimide film]

The polyamide acid solutions obtained for Reference Examples 1 and 2 were applied onto a mirror-finished endless continuous belt of stainless steel by means of a die coater (width of application: 1240 mm), and dried at 90 to 115°C for 10 minutes. The solutions dried into self-supporting polyamide acid films were peeled off from a support, and the opposite ends were cut to obtain respective green films.

These green films thus obtained were passed through a pin tenter having pin sheets on which pins were arranged so that the pins were at regular intervals when the pin sheets are positioned side by side. The film ends were held with pins inserted thereto. The pin sheet interval was adjusted in such a manner that prevents breakage of the films and unnecessary sagging. It was conveyed so that the final pin sheet interval was 1140 mm. Heating was performed in a first stage at 170°C for 2 minutes, in a second stage at 230°C for 2 minutes, and in a third stage at 485°C for 6 minutes to promote imidization reaction. After this, the temperature was decreased to room temperature in 2 minutes. Film's opposite ends of less planarity were cut off with a slitter. The films were rolled to obtain respective brown polyimide films of film 1 to film 4. The results of measurement of properties of each polyimide film thus obtained are shown in Table 3.

Table 3

| Film No. | | | 1 | 2 | 3 | 4 |
|---|---|---|---|---|---|---|
| polyamide acid | | | A | B | A | B |
| thickness | | μm | 5 | 5 | 38 | 38 |
| tensile rupture strength | MD | MPa | 338 | 336 | 330 | 336 |
| | TD | | 323 | 290 | 325 | 290 |
| tensile elastic modulus | MD | GPa | 7.1 | 8.3 | 6.8 | 8.3 |
| | TD | | 6.7 | 9.8 | 6.6 | 9.8 |

(continued)

| Film No. | | | 1 | 2 | 3 | 4 |
|---|---|---|---|---|---|---|
| polyamide acid | | | A | B | A | B |
| elongation | MD | % | 34.4 | 38.8 | 34.0 | 38.8 |
| | TD | | 31.9 | 50.4 | 32.3 | 50.4 |
| (CTE) coefficient of linear expansion | MD | ppm/°C | 0.9 | 9.8 | 1.3 | 10.0 |
| | TD | | 1.0 | 9.9 | 1.1 | 9.9 |

[Formation of polyimide films 5-10]

The polyamide acid solutions obtained for Production Examples were applied onto a mirror-finished endless continuous belt of stainless steel by means of a die coater (width of application: 1240 mm), and dried at 90 to 115°C for 10 minutes. The solutions dried into self-supporting polyamide acid films were peeled off from a support, and the opposite ends were cut to obtain respective green films.

These green films thus obtained were passed through a pin tenter having pin sheets on which pins were arranged so that the pins were at regular intervals when the pin sheets are positioned side by side. The film ends were held with pins inserted thereto. The pin sheet interval was adjusted in such a manner that prevents breakage of the films and unnecessary sagging. It was conveyed so that the final pin sheet interval was 1140 mm. Heating was performed in a first stage at 170°C for 2 minutes, in a second stage at 230°C for 2 minutes, and in a third stage at 485°C for 6 minutes to promote imidization reaction. After this, the temperature was decreased to room temperature in 2 minutes. Film's opposite ends of less planarity were cut off with a slitter. The films were rolled to obtain respective brown polyimide films of film 5 to film 10. The results of measurement of properties and other details of each polyimide film thus obtained are shown in Table 4.

[Formation of polyimide film 11]

Polyamide acid solution A1 was applied by a comma coater on a non-lubricant surface of a polyethylene terephthalate film A-41 (manufactured by Toyobo Co., Ltd.), dried at 110°C for 5 minutes, and thereafter a laminated body of the polyamide acid film A1 layer and a support was rolled without peeling the layer off from the support. The thickness of the obtained polyamide acid film A1 layer was, in the form of the resultant polyimide film, 30 μm.

The rolled laminated body of the polyamide acid film A1 layer and the support thus obtained was attached to a wind portion of a film forming machine, the above-described polyamide acid solution A2 was applied by a comma coater on a surface of the polyamide acid film A1 layer so that the resultant polyimide film is 8 μm, and dried at 110°C for 20 minutes to obtain a double layer polyamide acid film. The multilayer polyamide acid film was peeled off from the support, thereafter passed through a pin tenter having three heat treatment zones, heat treated in a first stage at 150°C for 2 minutes, in a second stage at 220°C for 2 minutes, and in a third stage at 475°C for 4 minutes, and slit into 500 mm width to obtain a multilayer polyimide film. The film thus obtained was used as film 11.

The results of measurement of properties and other details of the obtained polyimide film are shown in Table 4.

Table 4

| Film No. | | | 5 | 6 | 7 | 8 | 9 | 10 | 11 |
|---|---|---|---|---|---|---|---|---|---|
| polyamide acid | | | A1 | A2 | A1 | B1 | B2 | C | A1, A2 |
| thickness | | μm | 38 | 38 | 5 | 38 | 38 | 38 | 38 |
| tensile rupture strength | MD | MPa | 466 | 450 | 437 | 521 | 511 | 339 | 521 |
| | TD | | 472 | 443 | 434 | 512 | 535 | 371 | 462 |
| tensile elastic modulus | MD | GPa | 7.3 | 7.1 | 6.9 | 9.4 | 8.4 | 3.2 | 5.9 |
| | TD | | 6.9 | 7.1 | 7.2 | 9.2 | 8.3 | 4.1 | 4.1 |
| elongation | MD | % | 35.1 | 33.4 | 31.5 | 46.4 | 38.7 | 75.6 | 35.5 |
| | TD | | 30.2 | 36.7 | 38.2 | 41.6 | 41.8 | 87.7 | 42.2 |

(continued)

| Film No. | | | 5 | 6 | 7 | 8 | 9 | 10 | 11 |
|---|---|---|---|---|---|---|---|---|---|
| polyamide acid | | | A1 | A2 | A1 | B1 | B2 | C | A1, A2 |
| (CTE) coefficient of linear expansion | MD | ppm/°C | 2.9 | 2.2 | 1.5 | 9.6 | 9.1 | 14 | 5· |
| | TD | | 3.1 | 2.8 | 1.4 | 9.7 | 8.9 | 16 | 5 |

In the table, the upper one of the PV values of Film No. 11 is the measurement of the A1 surface, and the lower one thereof is the measurement of the A2 surface.

<Examples 1-5>

(1) Plasma treatment

Each polyimide film cut into the A4 size and an adhesive-applied film of a base material of polyethylene terephthalate (PET) with a thickness of 50 μm were attached to each other and set in a plasma treatment machine manufactured by Nippo Electronics Co., Ltd. After a vacuum was generated, oxygen gas was fed and discharge was caused to perform plasma treatment of the polyimide film of 5 μm in thickness. The treatment was performed under the conditions that the degree of vacuum was 3 × 10 Pa, the gas flow rate was 1.5 SLM (Standard Litter per Minute), and the discharge power was 12 KW.

(2) Silane coupling treatment for inorganic substrate

A silane coupling agent ($(CH_3O)_3SiC_3H_6NH_2$) having been diluted with isopropyl alcohol to 0.5% was dropped on one surface of an inorganic substrate having been washed and dried. After the whole surface was wetted, the substrate was set upright. The liquid as flowing down was dropped off. After this, the substrate was left and dried in a down-flow clean booth at room temperature for one minute, and then placed on a holt plate of 105°C for one minute. Silane coupling treatment was thus performed.

The liquid of the applied silane coupling agent ($(CH_3O)_3SiC_3H_6NH_2$) diluted with isopropyl alcohol to 0.5% was in a range of 1 to 6 mg/cm$^2$. Therefore, the amount of applied silane coupling agent ($(CH_3O)_3SiC_3H_6NH_2$) is considered as being in a range of 5 to 30 μg/cm$^2$.

(3) Vacuum press

On a specular SUS plate, each plasma-treated polyimide film from which the adhesive-applied PET base material was peeled off was superposed so that the plasma-treated surface was located on the side opposite to the side abutting on the SUS plate. On the polyimide film, the silane-coupling-treated surface of the inorganic substrate was laid, and they were placed in a vacuum press machine.

A press faceplate was used to press them superposed on each other (sample). Then, a vacuum was generated, the temperature was increased at a rate of 5°C/min to 300°C. The degree of vacuum was kept from 10 Pa to 1 Pa and the temperature was maintained for 10 minutes. After this, the temperature was decreased at a rate of 5°C/min. When the temperature was decreased to not more than 100°C, the pressure was changed back to the atmospheric pressure, and the force applied by pressing was removed. Here, a vacuum press machine manufactured by Imoto Machinery Co., Ltd. (11FD) was used.

Evaluations of obtained laminated bodies are shown in Table 5 below.

In the table, simulation evaluations were made by depositing an Si thin film through sputtering on the laminated body obtained for each of the examples and comparative examples, for use as a simulated device layer.

The thin film was formed by high-frequency magnetron sputtering. The film was cut into the A5 size, on which a stainless frame having an opening was placed, and the film was secured to a substrate holder in a sputtering apparatus. The substrate holder and the film surface were fixed so that they closely fit with each other. Thus, a refrigerant may be flown in a substrate holder to set the film temperature. Then, the film surface was plasma-treated. The conditions for the plasma treatment were that the treatment was done in argon gas, the frequency was 13.56 MHz, the output was 200 W, the gas pressure was $1\times10^{-3}$ Torr, the temperature during the treatment was 2°C, and the treatment time was 2 minutes. Then, under the conditions that the frequency was 13.56 MHz, the output was 450 W, and the gas pressure was $3\times10^{-3}$ Torr, a target of a silicon metal was used and, in an argon ambient, RF magnetron sputtering method was used to sputter the silicon at a rate of 10 nm/sec to form a silicon thin film of 0.1 μm in thickness.

After this, while nitrogen gas was fed in a muffle furnace, the sample was placed therein, the temperature was raised so that the temperature was 300°C after an hour, the temperature was kept at 300°C for 1 hour, a heater was powered off, and the temperature was decreased back to room temperature through natural cooling. By this operation, a stability of the case where the temperature process was simulated was obtained.

A sample without peel, bulge, and warp is evaluated as A, a sample without peel and bulge is evaluated as B, a sample with slight peel and bulge is evaluated as C, and a sample with bulge is evaluated as D.

Table 5

| Example No. | | | 1 | 2 | 3 | 4 | 5 |
|---|---|---|---|---|---|---|---|
| Film No. | | | 1 | 2 | 3 | 4 | 1 |
| polyamide acid | | | A | B | A | B | A |
| thickness | | μm | 5 | 5 | 38 | 38 | 5 |
| (CTE) coefficient of linear expansion | MD | ppm/°C | 0.9 | 9.8 | 1.3 | 10.0 | 0.9 |
| | TD | | 1.0 | 9.9 | 1.1 | 9.9 | 1.0 |
| inorganic substrate | | | Si wafer | Si wafer | glass | glass | glass |
| inorganic substrate thickness | | | 725 | 725 | 700 | 700 | 700 |
| inorganic substrate coefficient of linear expansion | | ppm/°C | 3.0 | 3.0 | 1.5 | 1.5 | 1.5 |
| peel strength | | N/cm | 1.1 | 0.6 | 1.2 | 0.6 | 1.3 |
| simulation evaluation | | | *A* | *B* | *A* | *B* | *A* |

<Comparative Examples 1-4>

Each polyimide film cut into the A4 size was used. The polyimide film was not plasma-treated, and an inorganic substrate was not silane-coupling-treated. In a similar manner to the above-described examples, on a specular SUS plate, each plasma-treated polyimide film from which the adhesive-applied PET base material was peeled off was superposed. On the polyimide film, the inorganic substrate was superposed, and they were placed in a vacuum press machine.

A press faceplate was used to press them superposed on each other (sample). Then, a vacuum was generated, the temperature was increased at a rate of 5°C/min to 300°C. The degree of vacuum was kept from 10 Pa to 1 Pa and the temperature was maintained for 10 minutes. After this, the temperature was decreased at a rate of 5°C/min. When the temperature was decreased to not more than 100°C, the pressure was changed back to the atmospheric pressure, and the force applied by pressing was removed. Here, a vacuum press machine manufactured by Imoto Machinery Co., Ltd. (11FD) was used. Evaluations of obtained laminated bodies are shown in Table 6 below.

Table 6

| Comparative Example No. | | | 1 | 2 | 3 | 4 |
|---|---|---|---|---|---|---|
| Film No. | | | 1 | 2 | 3 | 4 |
| polyamide acid | | | A | B | A | B |
| thickness | | μm | 5 | 5 | 38 | 38 |
| (CTE) coefficient of linear expansion | MD | ppm/°C | 0.9 | 9.8 | 1.3 | 10.0 |
| | TD | | 1.0 | 9.9 | 1.1 | 9.9 |
| inorganic substrate | | | Si wafer | Si wafer | glass | glass |
| inorganic substrate thickness | | | 725 | 725 | 700 | 700 |
| inorganic substrate coefficient of linear expansion | | ppm/°C | 3.0 | 3.0 | 1.5 | 1.5 |
| peel strength | | N/cm | 0.05 | 0.06 | 0.03 | 0.04 |
| simulation evaluation | | | *D* | *D* | *D* | *D* |

<Comparative Examples 5-8>

Comparative Example 5

This example was the same as Example 1 except that the polyimide layer was not vacuum-plasma-treated before vacuum press.

Comparative Example 6

This example was the same as Example 1 except that the inorganic substrate was not silane-coupling-treated.

Comparative Example 7

This example was the same as Example 5 except that the polyimide layer was not vacuum-plasma-treated before vacuum press.

Evaluations of obtained laminated bodies are shown in Table 7 below.

Table 7

| Comparative Example No. | | | 5 | 6 | 7 |
|---|---|---|---|---|---|
| Film No. | | | 1 | 1 | 3 |
| polyamide acid | | | A | A | A |
| thickness | | μm | 5 | 5 | 38 |
| (CTE) coefficient of linear expansion | MD | ppm/°C | 0.9 | 0.9 | 1.3 |
| | TD | | 1.0 | 1.0 | 1.1 |
| inorganic substrate | | | Si wafer | Si wafer | glass |
| inorganic substrate thickness | | | 725 | 725 | 700 |
| inorganic substrate coefficient of linear expansion | | ppm/°C | 3.0 | 3.0 | 1.5 |
| peel strength | | N/cm | 0.40 | 0.15 | 0.35 |
| simulation evaluation | | | *C* | *D* | *C* |

<Examples 6-11>

(Example 6)

A silane coupling agent (3-aminopropyltrimethoxysilane) was diluted with isopropyl alcohol to 1%. After this, an Si wafer having been washed and dried was rotated by a spin coater at 3000 rpm, and the silane coupling agent was dropped on the wafer to wet the whole surface. After 30 seconds from the drop, the rotation was stopped. The surface at this time appeared to be dry. The wafer was placed on a hot plate of 130°C for 1 minute, and thereafter vacuum press was performed. For the vacuum press, a vacuum was generated by a rotary pump, and the press was carried out at a degree of vacuum of not more than $10^{+2}$ Pa, at a pressure of 10 MPa, and at 300°C for 10 minutes. Before the vacuum press, polyimide film 5 was used and this film was vacuum-plasma-treated. The vacuum plasma treatment was performed by means of RIE mode RF plasma using a parallel plate electrode. Oxygen gas was fed into a vacuum chamber, a high-frequency electric power of 13.54 MHz was applied, and the treatment was performed for 3 minutes. The result of evaluation and other details are shown in Table 8.

(Example 7)

This example was the same as Example 6 except that a glass plate was used as the inorganic layer. The result of evaluation and other details are shown in Table 8.

(Example 8)

This example was the same as Example 6 except that film 7 of 5 μm was used as the polyimide layer. The result of evaluation and other details are shown in Table 8.

(Example 9)

A silane coupling agent (3-aminopropyltrimethoxysilane) was diluted with isopropyl alcohol to 1%. After this, polyimide film 1 was immersed in this liquid. After immersed for 3 minutes, the film was removed from the liquid and practically dried, and thereafter further heated to be dried with a hot air dryer at 130°C for 5 minutes. Then, a wafer having been washed and dried was vacuum-chucked with a wafer vacuum chuck provided with a heater heated to 200°C, and thereafter polyimide film 5 having been immersed in a silane coupling agent solution, heated and dried was pressed against the wafer on the chuck by means of a roller so that the film is attached to the wafer. The polyimide film was cut to conform to the shape of the periphery of the wafer, and then vacuum press was performed. For the vacuum press, a vacuum was generated by a rotary pump, and the press was carried out at a degree of vacuum of not more than $10^{+2}$ Pa, at a pressure of 10 MPa, and at 300°C for 10 minutes. Before the vacuum press, the polyimide layer was vacuum-plasma treated. The result of evaluation and other details are shown in Table 9.

(Example 10)

This example was the same as Example 6 except that film 8 was used as the polyimide layer. The result of evaluation and other details are shown in Table 9.

(Example 11)

This example was the same as Example 6 except that film 11 was used as the polyimide layer and the surface to be attached was A1 surface. The result of evaluation and other details are shown in Table 9.

Table 8

| | unit | Example 6 | Example 7 | Example 8 |
|---|---|---|---|---|
| film used | | 5 | 5 | 7 |
| type of inorganic layer | | Si wafer | glass plate | Si wafer |
| inorganic layer thickness | μm | 725 | 700 | 725 |
| inorganic layer CTE | ppm/°C | 3 | 1.5 | 3 |
| silane coupling agent layer thickness | nm | 15 | 15 | 4 |
| peel strength | N/cm | 1.7 | 1.5 | 1.6 |

Table 9

| | unit | Example 9 | Example 10 | Example 11 |
|---|---|---|---|---|
| film used | | 5 | 8 | 11 |
| type of inorganic layer | | Si wafer | Si wafer | Si wafer |
| inorganic layer thickness | μm | 725 | 725 | 725 |
| inorganic layer CTE | ppm/°C | 3 | 3 | 3 |
| silane coupling agent layer thickness | nm | 15 | 15 | 15 |
| peel strength | N/cm | 1.9 | 1.3 | 0.9 |

<Comparative Examples 9-15>

(Comparative Example 9)

This example was the same as Example 6 except that the polyimide layer was not vacuum-plasma-treated before vacuum press. The result of evaluation and other details are shown in Table 10.

(Comparative Example 10)

This example was the same as Example 6 except that the silane coupling agent was not used for the Si wafer layer before vacuum press. The result of evaluation and other details are shown in Table 10.

(Comparative Example 11)

This example was the same as Comparative Example 9 except that a glass plate was used as the inorganic layer. The result of evaluation and other details are shown in Table 10.

(Comparative Example 12)

This example was the same as Comparative Example 9 except that film 6 was used as the film to be used. The result of evaluation and other details are shown in Table 11.

(Comparative Example 13)

This example was the same as Comparative Example 9 except that film 9 was used as the film to be used. The result of evaluation and other details are shown in Table 11.

(Comparative Example 14)

This example was the same as Comparative Example 9 except that a glass plate was used as the inorganic layer and film 10 was used as the film to be used. The result of evaluation and other details are shown in Table 11.

(Comparative Example 15)

This example was the same as Example 6 except that film 11 was used as the polyimide film and the surface to be attached was A2 surface. The result of evaluation and other details are shown in Table 11.

Table 10

| | unit | Comparative Example 9 | Comparative Example 10 | Comparative Example 11 |
|---|---|---|---|---|
| film used | | 5 | 5 | 5 |
| type of inorganic layer | | Si wafer | Si wafer | glass plate |
| inorganic layer thickness | μm | 725 | 725 | 700 |
| inorganic layer CTE | ppm/°C | 3 | 3 | 1.5 |
| silane coupling agent layer thickness | nm | 15 | 0 | 15 |
| peel strength | N/cm | 0.05 | 0.05 | 0.03 |

Table 11

| | unit | Comparative Example 12 | Comparative Example 13 | Comparative Example 14 | Comparative Example 15 |
|---|---|---|---|---|---|
| film used | | 6 | 9 | 10 | 11 |

(continued)

| | unit | Comparative Example 12 | Comparative Example 13 | Comparative Example 14 | Comparative Example 15 |
|---|---|---|---|---|---|
| type of inorganic layer | | Si wafer | Si wafer | glass plate | Si wafer |
| inorganic layer thickness | μm | 725 | 725 | 700 | 725 |
| inorganic layer CTE | ppm/°C | 3 | 3 | 1.5 | 3 |
| silane coupling agent layer thickness | nm | 15 | 15 | 15 | 15 |
| peel strength | N/cm | 0.04 | 0.05 | 0.03 | 0.09 |

<Examples 12-19>

Respective processes of Examples 12 to 19 were all performed in a class 10000 clean room. In particular, after heating with a hot plate, the polyimide film was immediately superposed for preventing adhesion of foreign matters. Before spin coating with the silane coupling agent, ethanol was applied onto the substrate placed on a spin coater and the substrate was rotated at 1000 rpm and dried for washing the substrate. Immediately after this, the silane coupling agent was applied. A cover is placed on the spin coater and clean dry air was fed into the spin coater to prevent adhesion of foreign matters. This method was not performed for Comparative Examples 16 to 23.

(Example 12)

A silane coupling agent (3-aminopropyltrimethoxysilane) was diluted with isopropyl alcohol to 1%. Then, an Si wafer having been washed and dried was rotated by a spin coater at 500 rpm, and the silane coupling agent was dropped on the wafer to wet the whole surface. After 30 seconds from the drop, rotation was stopped. The surface at this time appeared to be dry. The wafer was placed on a hot plate of 130°C for 1 minute, and thereafter vacuum press was performed. For the vacuum press, a vacuum was generated by a rotary pump, and the press was carried out at a degree of vacuum of not more than $10^{+2}$ Pa, at a pressure of 10 MPa, and at 300°C for 10 minutes. Before the vacuum press, polyimide layer film 5 was used and this film was vacuum-plasma-treated. The vacuum plasma treatment was performed by means of RIE mode RF plasma using a parallel plate electrode. Ar gas was fed into a vacuum chamber, a high-frequency electric power of 13.54 MHz was applied, and the treatment was performed for 3 minutes. The result of evaluation and other details are shown in Table 12.

(Example 13)

This example was the same as Example 12 except that a glass plate was used as the inorganic layer. The result of evaluation and other details are shown in Table 12.

(Example 14)

This example was the same as Example 12 except that film 7 of 5 μm was used as the polyimide layer. The result of evaluation and other details are shown in Table 12.

(Example 15)

A silane coupling agent (3-aminopropyltrimethoxysilane) was diluted with isopropyl alcohol to 1%. After this, a polyimide film was immersed in this liquid. After immersed for 3 minutes, the film was removed from the liquid and practically dried, and thereafter further heated to be dried with a hot air dryer at 130°C for 5 minutes. Then, a wafer having been washed and dried was vacuum-chucked with a wafer vacuum chuck provided with a heater heated to 200°C, and thereafter polyimide film 5 having been immersed in a silane coupling agent solution, heated and dried was pressed against the wafer on the chuck by means of a roller so that the film was attached to the wafer. The polyimide film was

cut to conform to the shape of the periphery of the wafer, and then vacuum press was performed. For the vacuum press, a vacuum was generated by a rotary pump, and the press was carried out at a degree of vacuum of not more than $10^{+2}$ Pa, at a pressure of 10 MPa, and at 300°C for 10 minutes. Before the vacuum press, the polyimide layer was vacuum-plasma treated. The result of evaluation and other details are shown in Table 13.

(Example 16)

This example was the same as Example 12 except that the silane coupling agent (3-aminopropyltrimethoxysilane) was replaced with N-2-(aminoethyl)-3-aminopropyltrimethoxysilane. The result of evaluation and other details are shown in Table 13.

(Example 17)

This example was the same as Example 1 except that film 11 was used as the polyimide layer and the surface to be attached was A1 surface. The result of evaluation and other details are shown in Table 13.

(Example 18)

This example was the same as Example 12 except that a 3mm-thick plate of SUS403 was used instead of the Si wafer. The result of evaluation and other details are shown in Table 14.

(Example 19)

This example was the same as Example 12 except that a $Al_2O_3$ substrate mirror-finished surface was used instead of the Si wafer. The result of evaluation and other details are shown in Table 14.

Table 12

| | unit | Example 12 | Example 13 | Example 14 |
|---|---|---|---|---|
| film used | | 5 | 5 | 7 |
| type of inorganic layer | | Si wafer | glass plate | Si wafer |
| inorganic layer thickness | μm | 725 | 700 | 725 |
| inorganic layer CTE | ppm/°C | 3 | 1.5 | 3 |
| silane coupling agent layer thickness | nm | 15 | 15 | 4 |
| peel strength | N/cm | 4.1 | 2.9 | 3.2 |

Table 13

| | unit | Example 15 | Example 16 | Example 17 |
|---|---|---|---|---|
| film used | | 5 | 5 | 11 |
| type of inorganic layer | | Si wafer | Si wafer | Si wafer |
| inorganic layer thickness | μm | 725 | 725 | 725 |
| inorganic layer CTE | ppm/°C | 3 | 3 | 3 |
| silane coupling agent layer thickness | nm | 15 | 1 5 1 5 | 15 |
| peel strength | N/cm | 3.9 | 2.7 | 2.9 |

Table 14

| | unit | Example 18 | Example 19 |
|---|---|---|---|
| film used | | 5 | 5 |

(continued)

| | unit | Example 18 | Example 19 |
|---|---|---|---|
| type of inorganic layer | | SUS304 | $Al_2O_3$ |
| inorganic layer thickness | μm | 1000 | 1000 |
| inorganic layer CTE | ppm/°C | 9.9 | 7.9 |
| silane coupling agent layer thickness | nm | 15 | 15 |
| peel strength | N/cm | 2.8 | 3.2 |

(Formation Example 1 of penetrating portion and circuit portion)

The film used for formation of the laminated body for Example 12 was cut into the A4 size, and thereafter irradiated in advance with a $CO_2$ laser with an electric current value of 12 A, a frequency of 200 Hz, ON time of 24 μsec, and four shot times to make a hole of ϕ80 μm. Then, the laminated body was formed. No particular problem arose in attachment of the film, and the film could be attached similarly to Example 12.

After this, a stainless frame having an opening was placed on the film, and it was secured to a substrate holder in a sputtering apparatus. The substrate holder and the film surface were fixed so that they closely fit with each other. Thus, a refrigerant may be flown in a substrate holder to set the film temperature. Then, the film surface was plasma-treated. The conditions for the plasma treatment were that the treatment was done in argon gas, the frequency was 13.56 MHz, the output was 200 W, the gas pressure was $1\times10^{-3}$ Torr, the temperature during the treatment was 2°C, and the treatment time was 2 minutes. Subsequently, under the conditions that the frequency was 13.56 MHz, the output was 450 W, and the gas pressure was $3\times10^{-3}$ Torr, a target of nickel-chromium alloy (10% by mass of chromium) was used and, in an argon ambient, DC magnetron sputtering method was used to form a nickel-chromium alloy coating (base layer) at a rate of 1 nm/sec to a thickness of 7 nm. Then, a refrigerant was flown with the temperature controlled to 2°C at the rear surface of the sputter surface of the substrate so that the substrate temperature was 2°C. Sputtering was performed in the state of contact with an SUS plate of the substrate holder. Copper was deposited at a rate of 10 nm/sec to form a copper thin film of 0.25 μm in thickness. From these films, a base metal thin-film-formed film was obtained. Respective thicknesses of the copper and NiCr layers were confirmed with the x-ray fluorescence method. The base metal thin-film formed film formed of the films was secured to a plastic frame, and a copper sulfide plating bath was used to form a thick copper layer of the thickness shown in the table. The conditions of electrolytic plating were immersion in an electrolytic plating solution (80 g/l of copper sulfate, 210 g/l of sulfuric acid, HCl, brightner of small amount) and electric current of 1.5 $A/dm^2$. Subsequently, a heat treatment and dry process was performed at 120°C for 10 minutes to obtain a metallized polyimide film using each film.

Then, on the copper thin film, a copper electrolytic plating was applied. The resultant metallized film was re-secured to the plastic frame, and copper sulfate plating bath was used to form a thick copper plating layer (thick layer) of 4 μm in thickness and subsequently it was dried at 80°C for 1 minute to obtain the metallized polyimide film as intended.

The resultant metallized polyimide film was used and, after a photoresist FR-200 manufactured by Shipley was applied and dried, contact exposure with a glass photomask was performed, and development was performed with an aqueous solution of KOH of 1.2% by mass. Next, an etching line of cupric chloride including HCl and hydrogen peroxide was used to perform etching at 40°C and with a spray pressure of 2 $kgf/cm^2$ to form a series of lines of line/space of 100 μm/100 μm as a test pattern. After this, non-electrolytic tin plating was performed to 0.5 μm, followed by annealing at 125°C for 1 hour. Observation with an optical microscope was made, and the favorable pattern without pattern residue was obtained.

(Formation Example 2 of penetrating portion and circuit portion)

The polyimide side of the laminated body formed for Example 12 was irradiated with a $CO_2$ laser with an electric current value of 12 A, a frequency of 200 Hz, ON time of 24 μsec, and four shot times to make a hole of ϕ80 μm, and thereafter a laminated body was formed. In the formed laminated body, the hole was opened in the film portion only. After this, similarly to Formation Example 1 of penetrating portion and circuit portion, a series of lines of line/space of 100 μm/100 μm was formed as a test pattern. Observation with an optical microscope was made, and the favorable pattern without pattern residue was obtained.

(Formation Example 3 of penetrating portion and circuit portion)

The polyimide side of the laminated body formed for Example 12 was irradiated with a $CO_2$ laser with an electric current value of 12 A, a frequency of 200 Hz, ON time of 24 μsec, and four shot times to make a hole of ϕ80 μm, and thereafter sputtering and plating were used to form Cu of 2 μm on one side. The sputtering was performed to deposit a base NiCr layer to 20 nm, deposit a Cu layer thereon to 200 nm without breaking vacuum, and thereafter electrolytic plating was performed so that the thickness was 2 μm. After this, an adhesive-applied PET film was attached to the side without Cu, and then non-electrolytic plating was performed to attach a non-electrolytic plating layer to the laser hole portion. Then, electrolytic plating was further performed to fill the laser hole with Cu.

After this, similarly to Formation Example 1 of penetrating portion and circuit portion, a series of lines of line/space of 50 μm/50 μm was formed as a test pattern. Observation with an optical microscope was made, and the favorable pattern without sagging and pattern residue was obtained.

<Comparative Examples 16-23>

(Comparative Example 16)

This example was the same as Example 12 except that the polyimide layer was not vacuum-plasma-treated before vacuum press. The result of evaluation and other details are shown in Table 15.

(Comparative Example 17)

This example was the same as Example 12 except that the silane coupling agent was not used for the Si wafer layer before vacuum press. The result of evaluation and other details are shown in Table 15.

(Comparative Example 18)

This example was the same as Comparative Example 16 except that a glass plate was used as the inorganic layer. The result of evaluation and other details are shown in Table 15.

(Comparative Example 19)

This example was the same as Comparative Example 16 except that film 6 was used as the film to be used. The result of evaluation and other details are shown in Table 15.

(Comparative Example 20)

This example was the same as Comparative Example 16 except that film 8 was used as the film to be used. The result of evaluation and other details are shown in Table 16.

(Comparative Example 21)

This example was the same as Comparative Example 16 except that film 9 was used as the film to be used. The result of evaluation and other details are shown in Table 16.

(Comparative Example 22)

This example was the same as Comparative Example 16 except that a glass plate was used as the inorganic layer and film 10 was used as the film to be used. The result of evaluation and other details are shown in Table 16.

(Comparative Example 23)

This example was the same as Example 12 except that film 11 was used as the polyimide layer and A2 surface was the attachment surface.. The result of evaluation and other details are shown in Table 16.

Table 15

| | unit | Comparative Example 16 | Comparative Example 17 | Comparative Example 18 | Comparative Example 19 |
|---|---|---|---|---|---|
| film used | | 5 | 5 | 5 | 6 |
| type of inorganic layer | | Si wafer | Si wafer | glass plate | Si wafer |
| inorganic layer thickness | μm | 725 | 725 | 700 | 725 |
| inorganic layer CTE | ppm/°C | 3 | 3 | 1.5 | 3 |
| silane coupling agent layer thickness | nm | 15 | 0 | 15 | 15 |
| peel strength | N/cm | 0.05 | 0.05 | 0.03 | 0.04 |

Table 16

| | unit | Comparative Example 20 | Comparative Example 21 | Comparative Example 22 | Comparative Example 23 |
|---|---|---|---|---|---|
| film used | | 8 | 9 | 10 | 11 |
| type of inorganic layer | | Si wafer | Si wafer | glass plate | Si wafer |
| inorganic layer thickness | μm | 725 | 725 | 700 | 725 |
| inorganic layer CTE | ppm/°C | 3 | 3 | 1.5 | 3 |
| silane coupling agent layer thickness | nm | 15 | 15 | 15 | 15 |
| peel strength | N/cm | 0.05 | 0.05 | 0.04 | 0.07 |

INDUSTRIAL APPLICABILITY

The laminated body of the present invention can be effectively used for a very small and thin device structure and the like. The polyimide film is superposed on the inorganic substrate and, on the very thin polyimide film excellent in insulation, heat resistance, and dimensional stability, circuits and devices can be formed precisely. Therefore, the laminated body can be effectively used for TAB, COF, interposer, sensor substrate, display device substrate, probe, integrated circuit substrate, composite substrate of ceramic substrate and polyimide substrate, substrate with metal heat dissipation plate, metal reinforced substrate, glass base substrate, additional substrate to a display device using glass substrate, composite device in which thin film device, thin film sensor, and electronic component are added on the circuits, and the like.

Further, the film is peeled off from the inorganic substrate as required, and accordingly the polyimide film with microscopic circuits formed thereon can be obtained. Therefore, it can effectively used for TAB, COF, interposer, sensor substrate, display device substrate, probe, integrated circuit substrate, composite substrate of ceramic substrate and polyimide substrate, substrate with metal heat dissipation plate, metal reinforced substrate, glass base substrate, additional substrate to a display device using glass substrate, composite device in which thin film device, thin film sensor, and electronic component are added on the circuits, and the like.

The laminated body is extremely advantageous for manufacture of device structures such as very small and thin sensors, and significantly contributes to the industry.

## Claims

1. A laminated body formed of at least an inorganic layer and a polyimide film, **characterized in that** the polyimide film is obtained by reaction between an aromatic tetracarboxylic acid and an aromatic diamine having a benzoxazole structure (skeleton), a silane coupling layer is included between the inorganic layer and the polyimide film, the silane coupling layer has a thickness of not more than 100 nm, the laminated body is formed by attaching to each other a surface of the inorganic layer of a type selected from a glass plate, a ceramic plate, a silicon wafer, and a metal, and at least one said polyimide film, with the silane coupling layer between the inorganic layer and the polyimide film, respective coefficients of linear expansion in a length direction and a width direction of the polyimide film are both -4 ppm/°C to +4 ppm/°C, 180-degree peel strength between the polyimide film and the inorganic layer of the laminated body is not less than 1.5 N/cm and not more than 10 N/cm, and a non-polyimide portion penetrates in a thickness direction of the polyimide film, wherein anhydrides, acids, and amido-bond derivatives of acids are collectively referred to as "aromatic tetracarboxylic acid".

2. The laminated body according to claim 1, wherein a value of (coefficient of linear expansion in the length direction of the inorganic layer - coefficient of linear expansion in the length direction of the polyimide film), and a value of (coefficient of linear expansion in the width direction of the inorganic layer - coefficient of linear expansion in the width direction of the polyimide film) are both -10 ppm/°C to +30 ppm/°C.

3. The laminated body according to 1 or 2, **characterized in that** the polyimide film has a thickness of 1 μm to 50 μm and, in the polyimide layer, at least a surface layer of 3 μm from a surface abutting on the inorganic layer contains no particle of a longer particle diameter of not less than 20 nm.

4. A laminated circuit board of a laminated body formed of at least an inorganic layer and a polyimide film, **characterized in that** the polyimide film is obtained by reaction between an aromatic tetracarboxylic acid and an aromatic diamine having a benzoxazole structure (skeleton), a silane coupling layer is included between the inorganic layer and the polyimide film, the silane coupling layer has a thickness of not more than 100 nm, the laminated body is formed by attaching to each other a surface of the inorganic layer of a type selected from a glass plate, a ceramic plate, a silicon wafer, and a metal, and at least one said polyimide film, with the silane coupling layer between the inorganic layer and the polyimide film, respective coefficients of linear expansion in a length direction and a width direction of the polyimide film are both -4 ppm/°C to +4 ppm/°C, and 180-degree peel strength between the polyimide film and the inorganic layer of the laminated body is not less than 1.5 N/cm and not more than 10 N/cm, wherein anhydrides, acids, and amido-bond derivatives of acids are collectively referred to as "aromatic tetracarboxylic acid".

5. The laminated circuit board according to claim 4, **characterized in that** a non-polyimide portion penetrates in a thickness direction of the polyimide film in the laminated body.

6. The laminated circuit board according to claim 4 or 5, wherein a value of (coefficient of linear expansion in the length direction of the inorganic layer - coefficient of linear expansion in the length direction of the polyimide film), and a value of (coefficient of linear expansion in the width direction of the inorganic layer - coefficient of linear expansion in the width direction of the polyimide film) are both -10 ppm/°C to +30 ppm/°C.

7. The laminated circuit board according to any of claims 4 to 6, **characterized in that** the polyimide film has a thickness of 1 μm to 50 μm and, in the polyimide layer, at least a surface layer of 3 μm from a surface abutting on the inorganic layer contains no particle of a longer particle diameter of not less than 20 nm.

8. A method of manufacturing a laminated body as recited in any of claims 1 to 3, formed of at least of an inorganic layer and a polyimide film, **characterized in that** the polyimide film is obtained by reaction between an aromatic tetracarboxylic acid and an aromatic diamine and having respective coefficients of linear expansion in a length direction and a width direction of the polyimide film that are both -4 ppm/°C to +4 ppm/°C, at least one surface of the polyimide film has a surface roughness of not more than 15 nm in P-V value, the inorganic layer is of a type selected from a glass plate, a ceramic plate, a silicon wafer, and a metal and has at least one silane-coupling-treated surface, the surface having a surface roughness of not more than 15 nm in P-V value of the polyimide film, and the silane-coupling-treated surface of the inorganic layer are laid on each other, a pressure is applied to form a laminate of the inorganic layer and the polyimide film, and a process from the silane coupling treatment to the application of the pressure and lamination is performed in a clean room, wherein anhydrides, acids, and amido-bond derivatives of acids are collectively referred to as "aromatic tetracarboxylic acid".

**Patentansprüche**

1. Laminierter Körper, gebildet aus mindestens einer anorganischen Schicht und einem Polyimidfilm, **dadurch gekennzeichnet, dass** der Polyimidfilm durch Umsetzung zwischen einer aromatischen Tetracarbonsäure und einem aromatischen Diamin mit einer Benzoxazolstruktur (Skelett) erhalten ist, eine Silankupplungsschicht zwischen der anorganischen Schicht und dem Polyimidfilm eingeschlossen ist, die Silankupplungsschicht eine Dicke von nicht mehr als 100 nm aufweist, der laminierte Körper durch aneinander Anbringen einer Oberfläche der anorganischen Schicht von einer Art, ausgewählt aus einer Glasplatte, einer Keramikplatte, einem Siliziumwafer und einem Metall, und mindestens eines besagten Polyimidfilms mit der Silankupplungsschicht zwischen der anorganischen Schicht und dem Polyimidfilm gebildet ist, jeweilige lineare Ausdehnungskoeffizienten in einer Längenrichtung und einer Breitenrichtung des Polyimidfilms beide -4 ppm/°C bis +4 ppm/°C betragen, eine 180-Grad-Schälfestigkeit zwischen dem Polyimidfilm und der anorganischen Schicht des laminierten Körpers nicht weniger als 1,5 N/cm und nicht mehr als 10 N/cm beträgt, und sich ein Nicht-Polyimidbereich in eine Dickenrichtung des Polyimidfilms erstreckt, wobei Anhydride, Säuren und Amidobindungsderivate von Säuren gemeinsam als "aromatische Tetracarbonsäure" bezeichnet werden.

2. Laminierter Körper nach Anspruch 1, wobei ein Wert von (linearer Ausdehnungskoeffizient in der Längenrichtung der anorganischen Schicht - linearer Ausdehnungskoeffizient in der Längenrichtung des Polyimidfilms) und ein Wert von (linearer Ausdehnungskoeffizient in der Breitenrichtung der anorganischen Schicht - linearer Ausdehnungskoeffizient in der Breitenrichtung des Polyimidfilms) jeweils -10 ppm/°C bis +30 ppm/°C beträgt.

3. Laminierter Körper nach Anspruch 1 oder 2, **dadurch gekennzeichnet, dass** der Polyimidfilm eine Dicke von 1 μm bis 50 μm aufweist und in der Polyimidschicht mindestens eine Oberflächenschicht von 3 μm von einer an die anorganische Schicht angrenzenden Oberfläche kein Teilchen mit einem längeren Teilchendurchmesser von nicht weniger als 20 nm enthält.

4. Laminierte Leiterplatte von einem laminierten Körper, der aus mindestens einer anorganischen Schicht und einem Polyimidfilm gebildet ist, **dadurch gekennzeichnet, dass** der Polyimidfilm durch Umsetzung zwischen einer aromatischen Tetracarbonsäure und einem aromatischen Diamin mit einer Benzoxazolstruktur (Skelett) erhalten ist, eine Silankupplungsschicht zwischen der anorganischen Schicht und dem Polyimidfilm eingeschlossen ist, die Silankupplungsschicht eine Dicke von nicht mehr als 100 nm aufweist, der laminierte Körper durch aneinander Anbringen einer Oberfläche der anorganischen Schicht einer Art, ausgewählt aus einer Glasplatte, einer Keramikplatte, einem Siliziumwafer und einem Metall, und mindestens eines besagten Polyimidfilms mit der Silankupplungsschicht zwischen der anorganischen Schicht und dem Polyimidfilm gebildet ist, jeweilige lineare Ausdehnungskoeffizienten in einer Längenrichtung und einer Breitenrichtung des Polyimidfilms beide -4 ppm/°C bis +4 ppm/°C betragen und eine 180-Grad-Schälfestigkeit zwischen dem Polyimidfilm und der anorganischen Schicht des laminierten Körpers nicht weniger als 1,5 N/cm und nicht mehr als 10 N/cm beträgt, wobei Anhydride, Säuren und Amidobindungsderivate von Säuren gemeinsam als "aromatische Tetracarbonsäure" bezeichnet werden.

5. Laminierte Leiterplatte nach Anspruch 4, **dadurch gekennzeichnet, dass** sich ein Nicht-Polyimidbereich in eine Dickenrichtung des Polyimidfilms in dem laminierten Körper erstreckt.

6. Laminierte Leiterplatte nach Anspruch 4 oder 5, wobei ein Wert von (linearer Ausdehnungskoeffizient in der Längenrichtung der anorganischen Schicht - linearer Ausdehnungskoeffizient in der Längenrichtung des Polyimidfilms) und ein Wert von (linearer Ausdehnungskoeffizient in der Breitenrichtung der anorganischen Schicht - linearer Ausdehnungskoeffizient in der Breitenrichtung des Polyimidfilms) jeweils -10 ppm/°C bis +30 ppm/°C beträgt.

7. Laminierte Leiterplatte nach einem der Ansprüche 4 bis 6, **dadurch gekennzeichnet, dass** der Polyimidfilm eine Dicke von 1 μm bis 50 μm aufweist und in der Polyimidschicht mindestens eine Oberflächenschicht von 3 μm von einer an die anorganische Schicht angrenzenden Oberfläche kein Teilchen mit einem längeren Teilchendurchmesser von nicht weniger als 20 nm enthält.

8. Verfahren der Herstellung eines laminierten Körpers nach einem der Ansprüche 1 bis 3, der aus mindestens einer anorganischen Schicht und einem Polyimidfilm gebildet wird, **dadurch gekennzeichnet, dass** der Polyimidfilm durch Umsetzung zwischen einer aromatischen Tetracarbonsäure und einem aromatischen Diamin erhalten wird und jeweilige lineare Ausdehnungskoeffizienten in einer Längenrichtung und einer Breitenrichtung des Polyimidfilms, die beide -4 ppm/°C bis +4 ppm/°C betragen, aufweist, mindestens eine Oberfläche des Polyimidfilms eine Oberflächenrauhigkeit von nicht mehr als 15 nm in P-V-Wert aufweist, die anorganische Schicht von einer Art, ausgewählt

aus einer Glasplatte, einer Keramikplatte, einem Siliziumwafer und einem Metall, ist und mindestens eine silankupplungsbehandelte Oberfläche aufweist, die Oberfläche des Polyimidfilms, die eine Oberflächenrauhigkeit von nicht mehr als 15 nm in P-V-Wert aufweist, und die silankupplungsbehandelte Oberfläche der anorganischen Schicht aufeinander gelegt werden, ein Druck ausgeübt wird, um ein Laminat aus der anorganischen Schicht und dem Polyimidfilm zu bilden, und ein Verfahren von der Silankupplungsbehandlung bis zu der Anwendung des Drucks und der Laminierung in einem Reinraum durchgeführt wird, wobei Anhydride, Säuren und Amidobindungsderivate von Säuren gemeinsam als "aromatische Tetracarbonsäure" bezeichnet werden.

## Revendications

1. Corps stratifié constitué d'au moins une couche inorganique et d'un film de polyimide, **caractérisé en ce que** le film de polyimide est obtenu par réaction entre un acide tétracarboxylique aromatique et une diamine aromatique ayant une structure de benzoxazole (squelette), une couche de couplage silane est insérée entre la couche inorganique et le film de polyimide, la couche de couplage silane a une épaisseur de pas plus de 100 nm, le corps stratifié est formé par fixation l'une à l'autre d'une surface de la couche inorganique d'un type sélectionné parmi une plaque de verre, une plaque de céramique, une galette de silicium et un métal, et au moins un dudit film de polyimide, avec la couche de couplage silane entre la couche inorganique et le film de polyimide, des coefficients respectifs d'expansion linéaire dans le sens de la longueur et le sens de la largeur du film de polyimide vont tous deux de -4 ppm/°C à +4 ppm/°C, une résistance au pelage à 180 degrés entre le film de polyimide et la couche inorganique du corps stratifié n'est pas moins de 1,5 N/cm et pas plus de 10 N/cm, et une partie non-polyimide pénètre dans le sens de l'épaisseur du film de polyimide, dans lequel les anhydrides, les acides et les dérivés de liaison amido des acides sont collectivement appelés "acide tétracarboxylique aromatique".

2. Corps stratifié selon la revendication 1, dans lequel la valeur de (coefficient d'expansion linéaire dans le sens de la longueur de la couche inorganique - coefficient d'expansion linéaire dans le sens de la longueur du film de polyimide) et la valeur du (coefficient d'expansion linéaire dans le sens de la largeur de la couche inorganique - coefficient d'expansion linéaire dans le sens de la largeur du film de polyimide) vont toutes les deux de -10 ppm/°C à +30 ppm/°C.

3. Corps stratifié selon la revendication 1 ou 2, **caractérisé en ce que** le film de polyimide présente une épaisseur de 1 μm à 50 μm et, dans la couche de polyimide, au moins une couche superficielle de 3 μm depuis une surface aboutant sur la couche inorganique ne contient aucune particule d'un diamètre particulaire plus long que pas moins de 20 nm.

4. Circuit imprimé stratifiée d'un corps stratifié constituée d'au moins une couche inorganique et d'un film de polyimide, **caractérisée en ce que** le film de polyimide s'obtient par réaction entre un acide tétracarboxylique aromatique et une diamine aromatique ayant une structure de benzoxazole (squelette), une couche de couplage silane est insérée entre la couche inorganique et le film de polyimide, la couche de couplage silane a une épaisseur de pas plus de 100 nm, le corps stratifié est formé par fixation l'une à l'autre d'une surface de la couche inorganique d'un type sélectionné parmi une plaque de verre, une plaque de céramique, une galette de silicium et un métal, et au moins un dudit film de polyimide, avec la couche de couplage silane entre la couche inorganique et le film de polyimide, les coefficients respectifs d'expansion linéaire dans le sens de la longueur et le sens de la largeur du film de polyimide vont tous les deux de -4 ppm/°C à +4 ppm/°C et une résistance au pelage de 180 degrés entre le film de polyimide et la couche inorganique du corps stratifié n'est pas moins de 1,5 N/cm et pas plus de 10 N/cm, dans laquelle les anhydrides, les acides et les dérivés de liaison amido d'acides sont collectivement appelés "acide tétracarboxylique aromatique".

5. Circuit imprimé stratifiée selon la revendication 4, **caractérisée en ce qu'**une partie non polyimide pénètre dans le sens de l'épaisseur du film de polyimide dans le corps stratifié.

6. Circuit imprimé stratifiée selon la revendication 4 ou 5, dans laquelle la valeur de (coefficient d'expansion linéaire dans le sens de la longueur de la couche inorganique - coefficient d'expansion linéaire dans le sens de la longueur du film de polyimide) et la valeur de (coefficient d'expansion linéaire dans le sens de la largeur de la couche inorganique - coefficient d'expansion linéaire dans le sens de la largeur du film de polyimide) vont toutes les deux de -10 ppm/°C à +30 ppm/°C.

7. Circuit imprimé stratifiée selon l'une quelconque des revendications 4 à 6, **caractérisée en ce que** le film de polyimide a une épaisseur de 1 μm à 50 μm et, dans la couche de polyimide, au moins une couche superficielle

de 3 μm d'une surface aboutant sur la couche inorganique ne contient aucune particule d'un diamètre particulaire plus long que pas moins de 20 nm.

8. Procédé de fabrication d'un corps stratifié selon l'une quelconque des revendications 1 à 3, constitué d'au moins une couche inorganique et d'un film de polyimide, **caractérisé en ce que** le film de polyimide s'obtient par réaction entre un acide tétracarboxylique aromatique et une diamine aromatique et ayant des coefficients respectifs d'expansion linéaire dans le sens de la longueur et le sens de la largeur du film de polyimide qui vont tous deux de -4 ppm/°C à +4 ppm/°C, au moins une surface du film de polyimide présente une rugosité superficielle de pas plus de 15 nm en valeur P-V, la couche inorganique est d'un type sélectionné parmi une plaque de verre, une plaque de céramique, une galette de silicium et un métal et présente au moins une surface traitée de couplage silane, la surface présentant une rugosité superficielle de pas plus de 15 nm en valeur P-V du film de polyimide, et la surface traitée de couplage silane de la couche inorganique sont déposées l'une sur l'autre, une pression est appliquée pour former un stratifié de la couche inorganique et du film de polyimide, et un procédé du traitement de couplage silane à l'application de la pression et stratification est réalisé dans une pièce propre, dans lequel les anhydrides, les acides et les dérivés de liaison amido d'acides sont collectivement appelés "acide tétracarboxylique aromatique".

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 6056992 A
- JP 11504369 A
- JP 11505184 A